# EUROPEAN PATENT APPLICATION

(11) **EP 4 776 806 A1**
(43) Date of publication of application: **15.07.2026**
(21) Application number: 25225080.8
(22) Date of filing: 18.12.2025
(51) Int. Cl.: H10K 59/122, H10K 59/80, H10K 59/121

(54) **LIGHT EMITTING DISPLAY DEVICE AND ELECTRONIC DEVICE**

(30) Priority: 08.01.2025 KR 20250002571; 24.04.2025 KR 20250054062; 19.09.2025 US 202519333949
(71) Applicant: Samsung Display Co., Ltd., Yongin-si, Gyeonggi-do 17113 (KR)
(72) Inventor: KIM, Chanyoung, Yongin-si (KR); KIM, Changwook, Yongin-si (KR); BACK, Changhyun, Yongin-si (KR)
(74) Representative: Marks & Clerk LLP

(57) **Abstract**

A light emitting display device may include a substrate including a normal display area divided into an edge area and a central area, an anode located on the substrate, a pixel defining layer including a first opening configured to expose at least a portion of the anode, an emission layer located within the first opening of the pixel defining layer, a cathode configured to cover the pixel defining layer and the emission layer, an encapsulation layer configured to cover the cathode and including an organic encapsulation layer, and a second opening located on the encapsulation layer, and corresponding to the first opening of the pixel defining layer, where the second opening is divided into a central second opening located in the central area and an edge second opening located in the edge area, and where the edge second opening is smaller than the central second opening.

## Description

### BACKGROUND

### (A) FIELD

The present disclosure relates to a light emitting display device and an electronic device.

### (B) DESCRIPTION OF THE RELATED ART

A display device is a device that displays a screen, and includes a liquid crystal display (LCD), an organic light emitting diode (OLED) display, and the like. Such display devices are used in various electronic devices such as mobile phones, navigation devices, digital cameras, electronic books, portable game consoles, and terminals.

The display device such as the organic light emitting device may be folded or bent by using a flexible substrate.

In addition, in small electronic devices such as portable phones, optical elements such as cameras and optical sensors are formed in the bezel area around the display area, but as the size of the display screen is increased, the size of the peripheral area of the display area gradually decreases, and methods for locating the camera or the optical sensor on a back surface of the display area are being developed.

### SUMMARY

Embodiments are intended to provide a light emitting display device formed so that a bright band phenomenon that appears in an edge area located on an outermost side of a display area does not occur.

Embodiments are intended to provide a light emitting display device formed such that a phenomenon in which the brightness of the displayed image appears brighter in the edge area located on the outermost side of the display area does not occur.

In addition, embodiments are intended to provide a light emitting display device with an improved display quality since a bright band is not visible in the edge area of the display area in a flat light emitting display panel that is not curved or bent.

A light emitting display device may include a substrate including a normal display area divided into an edge area and a central area, an anode located on the substrate, a pixel defining layer including a first opening configured to extend to at least a portion of the anode, an emission layer located within the first opening of the pixel defining layer, a cathode configured to cover the pixel defining layer and the emission layer, an encapsulation layer configured to cover the cathode and including an organic encapsulation layer, and a second opening located on the encapsulation layer, and corresponding to the first opening of the pixel defining layer. The second opening is divided into a central second opening located in the central area and an edge second opening located in the edge area, and the edge second opening is smaller than a central second opening.

The edge second opening may be formed so that a horizontal distance from a boundary of the first opening corresponding to the edge second opening to a boundary of the edge second opening is smaller than a horizontal distance from the boundary of the first opening corresponding to the central second opening to a boundary of the central second opening.

The edge area may be located within a range of about 3 mm or less inward from an outermost edge of the display area.

The edge area may be located within a range of about 1 mm or less inward from the outermost edge of the display area.

The edge area may be located on a flat surface of the substrate.

The edge area may be divided into a plurality of areas, and edge second openings located in a same area among the plurality of areas and corresponding to a same color pixel may have a same size.

An edge second opening of an area located closest to the outermost edge of the display area, among the plurality of areas of the edge area, may be the smallest of the edge second openings, and an edge second opening of a farthest area from the outermost edge of the display area may be the largest of the edge second openings, and edge second openings in areas located sequentially inward from the outermost edge of the display area may gradually increase.

An additional area located between two adjacent areas among the plurality of areas of the edge area may include edge second openings located in each of two areas located on both sides of the additional area.

The additional area may include the edge second openings formed in each of two areas located on both sides of the additional area at a 1:1 ratio.

The first opening and the second opening of the display area may each have a circular planar shape, and the first opening and the second opening corresponding to each other may have centers at the same position in a plan view.

The first opening and/or the second opening located in the same area among the plurality of areas of the edge area and corresponding to different colors may have different sizes.

The edge second opening in the edge area has a planar shape extending toward an inner side of the display area.

The edge area may be located along four sides of the display area, extending directions along which the edge second opening may be elongated from the edge area located on both sides are the same, and there may be a total of four directions along which the edge second opening extends in the entire edge area.

The second opening may be located in a light blocking layer located in an upper portion of the pixel defining layer, or an overlapping light shielding area of a color filter.

A light emitting display device may include a substrate including a normal display area divided into an edge area and a central area, an anode located on the substrate, a pixel defining layer including a first opening configured to extend to at least a portion of the anode, an emission layer located within the first opening of the pixel defining layer, a cathode configured to cover the pixel defining layer and the emission layer, an encapsulation layer configured to cover the cathode and including an organic encapsulation layer, and a second opening located on the encapsulation layer, and corresponding to the first opening of the pixel defining layer. The second opening is divided into a central second opening located in the central area and an edge second opening located in the edge area, and the edge second opening in the edge area has a planar shape extending toward an inner side of the display area.

The edge area may be located along four sides of the display area, extending directions along which the edge second opening may be elongated from the edge area located on respective sides are the same, and there are four directions along which the edge second opening may extend in the entire edge area.

The second opening may be located in a light blocking layer located in an upper portion of the pixel defining layer, or an overlapping light shielding area of a color filter.

An electronic device may include a light emitting display device. The light emitting display device may include a substrate including a normal display area divided into an edge area and a central area, an anode located on the substrate, a pixel defining layer including a first opening configured to extend to at least a portion of the anode, an emission layer located within the first opening of the pixel defining layer, a cathode configured to cover the pixel defining layer and the emission layer, an encapsulation layer configured to cover the cathode and including an organic encapsulation layer, and a second opening located on the encapsulation layer, and corresponding to the first opening of the pixel defining layer. The second opening is divided into a central second opening located in the central area and an edge second opening located in the edge area, and the edge second opening is smaller than the central second opening.

The edge second opening may be formed so that a horizontal distance from a boundary of the first opening corresponding to the edge second opening to a boundary of the edge second opening is smaller than a horizontal distance from the boundary of the first opening corresponding to the central second opening to a boundary of the central second opening.

The edge area may be divided into a plurality of areas, and edge second openings located in a same area among the plurality of areas and corresponding to a same color pixel may have a same size.

Depending on the embodiment, the size of the opening (second opening) of the light blocking layer located in the edge area of the display area is reduced, or the opening has a structure that extends toward the inner side of the display area, so that the edge area does not appear brighter or the bright band is not visible.

Depending on the embodiment, the size of the opening (second opening) of the light shielding area on which two or more color filters located in the edge area of the display area overlap or the opening has a structure that extends toward the inner side of the display area, so that the edge area does not appear brighter or the bright band is not visible.

According to the embodiments, since a polarizing plate is not used, the brightness is not reduced by passing through the polarizing plate, so that the maximum brightness value of the light emitting display device is formed at 2500 nits or more, thereby providing a bright light emitting display device.

At least some of the above and other features of the invention are set out in the claims.

### BRIEF DESCRIPTION OF THE DRAWINGS

FIG. 1 is a schematic perspective view showing a usage state of a display device according to an embodiment.
FIG. 2 is an exploded perspective view of a display device according to an embodiment.
FIG. 3 is a block diagram of a display device according to an embodiment.
FIG. 4 is a perspective view schematically showing a light emitting display device according to an embodiment.
FIG. 5 is an enlarged top plan view of a partial area of a light emitting display device according to an embodiment.
FIG. 6 is a schematic cross-sectional view of a display panel according to an embodiment.
FIG. 7 is a cross-sectional view showing a second opening in a central area in a normal display area according to an embodiment.
FIG. 8 is a cross-sectional view showing a second opening in an edge area in a normal display area according to an embodiment.
FIG. 9 is a graph showing the thickness change of an organic encapsulation layer and a color filter in a display panel according to an embodiment.
FIG. 10 and FIG. 11 are drawings showing a bright band phenomenon of an edge area in a display panel of the Comparative Example.
FIG. 12 is a table showing a light emitting element cover insulation layer in a display panel according to an embodiment.
FIG. 13 is a graph showing the thickness change of an organic encapsulation layer in a display panel according to an embodiment.
FIG. 14 and FIG. 15 are drawings showing a method for calculating a path of light provided from an emission layer.
FIG. 16 is a drawing showing a change of a second opening in a display panel according to an embodiment.
FIG. 17 is a table summarizing sizes depending on positions of a second opening according to the embodiment of FIG. 16.
FIG. 18 is a drawing showing a change of a second opening in a display panel according to an embodiment.
FIG. 19 is a table summarizing sizes depending on positions of a second opening according to the embodiment of FIG. 18.
FIG. 20 is a drawing showing the manner of change of a second opening in an edge area in a display panel according to an embodiment.
FIG. 21 and FIG. 22 are schematic cross-sectional views of a display panel according to an embodiment.
FIG. 23 is a graph showing the transmittance depending on the wavelength of the color filter.
FIG. 24 and FIG. 25 are cross-sectional views of a light emitting display device according to an embodiment.
FIG. 26 is a cross-sectional view showing a second opening in a central area in a normal display area according to an embodiment.
FIG. 27 is a cross-sectional view showing a second opening in an edge area in a normal display area according to an embodiment.
FIG. 28 is a cross-sectional view showing a second opening in a central area in a normal display area according to an embodiment.
FIG. 29 is a cross-sectional view showing a second opening in an edge area in a normal display area according to an embodiment.
FIG. 30 is a schematic cross-sectional view of a display panel according to an embodiment.
FIG. 31 is a cross-sectional view of a light emitting display device according to an embodiment.
FIG. 32 is a schematic cross-sectional view of a display panel according to an embodiment.
FIG. 33 is a top plan view of a display panel according to an embodiment.
FIG. 34 is a schematic cross-sectional view of a display panel according to an embodiment of FIG. 33.
FIG. 35 and FIG. 36 are top plan views of a display area of a display panel according to an embodiment.
FIG. 37 is a top plan view of a display panel according to an embodiment.
FIG. 38 is an enlarged top plan view of a part of a display panel according to an embodiment of FIG. 37.

### DETAILED DESCRIPTION OF THE EMBODIMENTS

The present disclosure will be described more fully hereinafter with reference to the accompanying drawings, in which embodiments of the disclosure are shown. As those skilled in the art would realize, the described embodiments may be modified in various different ways, all without departing from the scope of the present disclosure.

In order to clearly describe the present disclosure, parts or portions that are irrelevant to the description are omitted, and identical or similar constituent elements throughout the specification are denoted by the same reference numerals.

Further, in the drawings, the size and thickness of each element are arbitrarily illustrated for ease of description, and the present disclosure is not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

It should be understood that when an element such as a layer, film, region, area, substrate, plate, or constituent element is referred to as being "on" or "above" another element, it can be directly on the other element or intervening elements may also be present. In contrast, when an element is referred to as being "directly on" another element, there are no intervening elements present. Further, in the specification, the word "on" or "above" means positioned on or below the object portion, and does not necessarily mean positioned on the upper side of the object portion based on a gravitational direction.

In addition, unless explicitly stated to the contrary, the word "comprise" and variations such as "comprises" and "comprising" should be understood to imply the inclusion of stated elements but not the exclusion of any other elements.

Further, throughout the specification, the phrase "in a plan view" or "on a plane" means viewing a target portion from the top, and the phrase "in a cross-sectional view" or "in a cross-section" means viewing a cross-section formed by vertically cutting a target portion from the side.

In addition, throughout the specification, the word "connected" does not only mean when two or more elements are directly connected, but when two or more elements are indirectly connected through other elements, and when they are physically connected or electrically connected, and further, it may be referred to by different names depending on position or function, and may also be referred to as a case in which parts that are substantially integrated are linked to each other.

In addition, throughout the specification, when it is said that an element such as a wire, layer, film, region, area, substrate, plate, or constituent element "is extended (or extends) in a first direction or second direction," this does not mean only a straight shape extending straight in the corresponding direction, but may mean a structure that substantially extends in the first direction or the second direction, is partially bent, has a zigzag structure, or extends while having a curved structure.

In addition, an electronic device (for example, a mobile phone, a TV, a monitor, or a laptop computer) included in a display device, a display panel, or the like described in the specification, or an electronic device included in a display device, a display panel, or the like manufactured by a manufacturing method described in the specification is not excluded from the scope of the present specification.

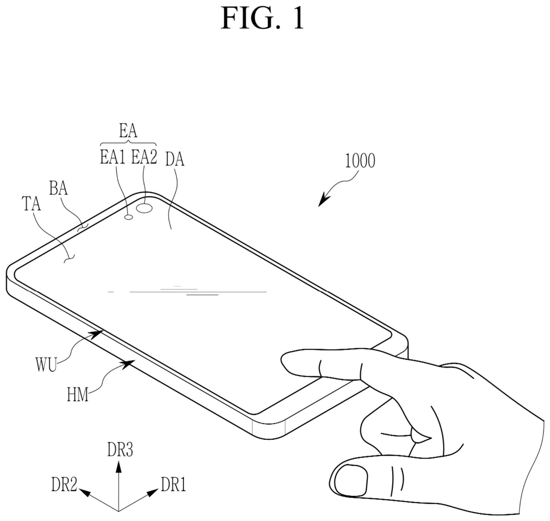

Hereinafter, a schematic structure of the display device will be described with reference to FIG. 1 to FIG. 3.

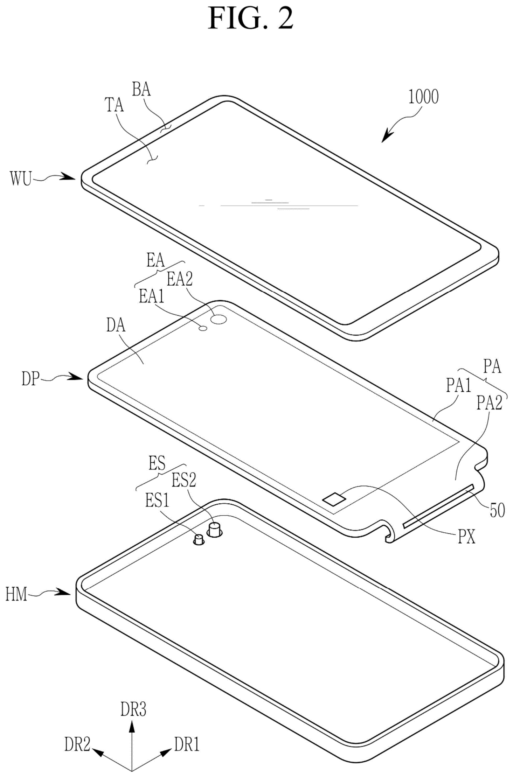

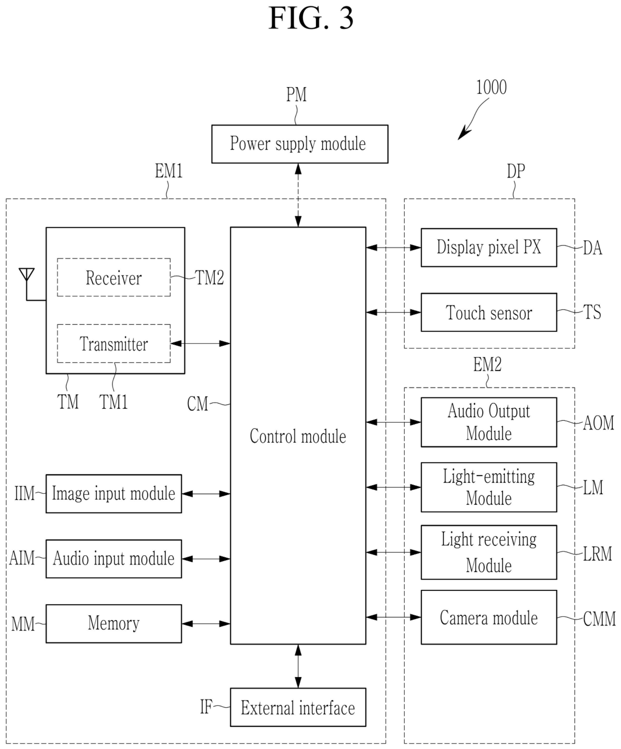

FIG. 1 is a schematic perspective view showing a usage state of a display device 1000 according to an embodiment, FIG. 2 is an exploded perspective view of a display device 1000 according to an embodiment, and FIG. 3 is a block diagram of a display device 1000 according to an embodiment.

Referring to FIG. 1, the display device 1000 according to an embodiment represents a device for displaying a motion picture or a still image, and may be used as a display screen of not only portable electronic devices such as a mobile phone, a smartphone, a tablet personal computer (tablet PC), a mobile communication terminal, an electronic notebook, an electronic book, a portable multimedia player (PMP), a navigation device, and an ultra-mobile PC (UMPC), but also various products such as a television, a laptop, a monitor, an advertisement board, and the Internet of Things (IOT). In addition, the display device 1000 according to an embodiment may be used with wearable devices such as a smart watch, a watch phone, a glasses-type display, and a head mounted display (HMD). In addition, the display device 1000 according to an embodiment may be used as an instrument panel of the vehicle, and a center information display (CID) located in a center fascia or dashboard of the vehicle, a room mirror display replacing a side-view mirror of the vehicle, and a display located on a rear side of a front seat as entertainment for the rear seat of the vehicle. To facilitate understanding and ease of description, FIG. 1 illustrates that the display device 1000 is used with a smartphone.

The display device 1000 may display an image on a display surface parallel to each of a first direction DR1 and a second direction DR2, along a third direction DR3. The display surface that displays the image may correspond to a front surface of the display device 1000, and may correspond to a front surface of a cover window WU. The image may include a still image as well as a motion image.

In the present embodiment, a front surface (or upper surface) and a back surface (or lower surface) of each member may be defined based on the direction along which the image is displayed. The front surface and the back surface may be opposed to each other in the third direction DR3, and a normal direction of each of the front surface and the back surface may be parallel to the third direction DR3. A spacing distance between the front surface and the back surface in the third direction DR3 may correspond to a thickness of the display panel in the third direction DR3.

The display device 1000 according to an embodiment may sense the user's input (see the hand in FIG. 1) applied from the outside. The user's input may include external inputs in various forms, such as a part of the user's body, light, heat, or pressure. In an embodiment, the user's input is illustrated as a hand of the user applied to the front surface. However, the present disclosure is not limited thereto. The user's input may be provided in various forms, and in addition, the display device 1000 may sense the user's input applied to the side surface or the back surface of the display device 1000, depending on the structure of the display device 1000.

Referring to FIG. 1 and FIG. 2, the display device 1000 may include the cover window WU, a housing HM, a display panel DP, and an optical element ES. In an embodiment, the cover window WU and the housing HM may be combined to form the appearance of the display device 1000.

The cover window WU may include an insulation panel. For example, the cover window WU may be made of glass, plastic, or a combination thereof.

The front surface of the cover window WU may define the front surface of the display device 1000. A transmitting area TA may be an optically transparent area. For example, the transmitting area TA may be an area having a visible ray transmittance of about 90% or more.

A blocking area BA may define a shape of the transmitting area TA. The blocking area BA may be adjacent to the transmitting area TA and may surround the transmitting area TA. The blocking area BA may be an area having a relatively low light transmittance compared to the transmitting area TA. The blocking area BA may include an opaque material configured to block light. The blocking area BA may have a predetermined color. The blocking area BA may be defined by a bezel layer provided in addition to a transparent substrate defining the transmitting area TA, or may be defined by an ink layer inserted into or colored by the transparent substrate.

The display panel DP may include a pixel PX configured to display an image and a driver 50, and the pixel PX may be located within a display area DA and a component area EA. The display panel DP may include the front surface including the display area DA and a non-display area PA. In an embodiment, the display area DA and the component area EA may be an area including pixels to display an image, and at the same time, may be an area sensing an external input by locating a touch sensor on an upper side in the third direction DR3 of the pixel.

The transmitting area TA of the cover window WU may at least partially overlap with the display area DA and the component area EA of the display panel DP. For example, the transmitting area TA may overlap with the front surface of the display area DA and the component area EA, or may overlap with at least a portion of the display area DA and the component area EA. Accordingly, the user may view an image through the transmitting area TA, or may provide an external input based on the image. However, the present disclosure is not limited thereto. For example, the area displaying the image and the area sensing the external input may be separated from each other.

The non-display area PA of the display panel DP may at least partially overlap with the blocking area BA of the cover window WU. The non-display area PA may be an area covered by the blocking area BA. The non-display area PA may be adjacent to the display area DA, and may surround the display area DA. The non-display area PA may not display an image, and a driving circuit or a driving wire for driving the display area DA may be located therein. The non-display area PA may include a first peripheral area PA1 located outside the display area DA and a second peripheral area PA2 including the driver 50, connection wires, and a bending area. In the embodiment of FIG. 2, the first peripheral area PA1 may be located on three sides of the display area DA, and the second peripheral area PA2 may be located on one remaining side of the display area DA.

In an embodiment, the display panel DP may be assembled in a flat state so that the display area DA, the component area EA, and the non-display area PA face the cover window WU. However, the present disclosure is not limited thereto. A part of the non-display area PA of the display panel DP may be bent. At this time, a portion of the non-display area PA faces the back surface of the display device 1000, so that the blocking area BA seen on the front surface of the display device 1000 may be reduced, and in FIG. 2, the second peripheral area PA2 may be bent and located on the back surface of the display area DA and then assembled.

In addition, the component area EA of the display panel DP may include a first component area EA1 and a second component area EA2. The first component area EA1 and the second component area EA2 may be at least partially surrounded by the display area DA. Although the first component area EA1 and the second component area EA2 are illustrated as spaced apart from each other, they are not limited thereto, and they may be connected at least partially. The first component area EA1 and the second component area EA2 may be an area below which the optical element ES (see FIG. 2; hereinafter, also referred to as a component) using infrared rays, visible rays, sound, or the like is located.

The display area DA (hereinafter, also referred to as a normal display area) and the component area EA may include a plurality of light emitting diodes, and a plurality of pixel circuit sections configured to generate a light emitting current and transfer it to each of the plurality of light emitting diodes. Here, one light emitting diode and one pixel circuit section are referred to as the pixel PX. In the display area DA and the component area EA, one pixel circuit section and one light emitting diode may be formed one-to-one. The display area DA may be divided into an edge area (not shown) located on an outermost side of the display area DA and a central area (not shown) located on an inner side of the edge area. The edge area may be located within a range of about 3 mm or less inward from an outermost edge of the display area DA, and located more than about 3 mm from the outermost edge inward to form the central area. That is, the edge area may be located along an outer edge of the display area DA, and may have a width of about 3 mm or less. The component area EA may be located in the central area.

Hereinafter, the pixel included in the display area DA (i.e., a normal display area) may be referred to as a normal pixel, the pixel located in the edge area among the display area DA may be referred to as an edge pixel, and the pixel located in the central area may be referred to as a normal center pixel. The edge area may be located on a flat surface of the substrate, and located within the flat display area DA. The edge area may emit light in the same direction as the central area, and the edge area may not be located in a bent area of the substrate.

The first component area EA1 may include a transmitting portion through which light and/or sound can pass and a display portion including a plurality of pixels. The transmitting portion may be located between adjacent pixels, and may be made of a layer through which light and/or sound can pass. The transmitting portion may be located between adjacent pixels, and depending on the embodiment, a layer that does not transmit light, such as a light blocking layer, may overlap with the first component area EA1. The number of pixels per unit area of normal pixels included in the display area DA (hereinafter, also referred to as resolution) and the number of pixels per unit area of the pixels (hereinafter, also referred to as a first component pixel) included in the first component area EA1 may be the same.

The second component area EA2 may include an area (hereinafter, also referred to as a light transmitting area) configured as a transparent layer to allow light to pass through, and the light transmitting area does not include a conductive layer or a semiconductor layer, and may be structured so that a layer including a light blocking layer-for example, a pixel definition layer and/or a light blocking layer-includes an opening overlapping with the location corresponding to the second component area EA2, thereby not blocking light. The number of pixels per unit area of pixels (hereinafter, also referred to as second component pixels) included in the second component area EA2 may be smaller than the number of pixels per unit area of normal pixels included in the display area DA. As a result, the resolution of the second components pixel may be lower than the resolution of the normal pixels.

Depending on the embodiment, instead of the light blocking layer, a light shielding area may be formed by overlapping at least two color filters, to block light of a specific wavelength range (e.g., visible ray).

Referring to FIG. 3, the display panel DP may further include a touch sensor TS, in addition to the display area DA including the pixel PX. The display panel DP may include the pixel PX for generating the image, and may be externally viewed by the user through the transmitting area TA. In addition, the touch sensor TS may be located in an upper portion of the pixel PX, and may sense an external input applied from the outside. The touch sensor TS may sense the external input provided to the cover window WU.

Referring back to FIG. 2, the second peripheral area PA2 may include a bent portion. The display area DA and the first peripheral area PA1 may have a flat state substantially parallel to a plane defined by the first direction DR1 and the second direction DR2, and a first side of the second peripheral area PA2 may extend from the flat state, pass through the bent portion, and then have the flat state again. As a result, at least a portion of the second peripheral area PA2 may be bent, and may be assembled to be located on the back surface of the display area DA. When being assembled, at least a portion of the second peripheral area PA2 may overlap with the display area DA in a plan view, and the blocking area BA of the display device 1000 may be decreased. However, the present disclosure is not limited thereto. For example, the second peripheral area PA2 may not be bent.

The driver 50 may be mounted on the second peripheral area PA2, and may be mounted on the bent portion or located on either side of the bent portion. The driver 50 may be provided in the form of a chip.

The driver 50 may be electrically connected to the display area DA and the component area EA, to transfer electrical signals to the pixels of the display area DA and the component area EA. For example, the driver 50 may provide data signals to the pixels PX located in the display area DA. In an embodiment, the driver 50 may include a touch driving circuit, and may be electrically connected to the touch sensor TS located in the display area DA and/or the component area EA. In an embodiment, the driver 50 may be designed to include various circuits in addition to the above-described circuits or to provide various electrical signals to the display area DA.

In an embodiment, the display device 1000 may include a pad portion located at an end point of the second peripheral area PA2, and be electrically connected to a flexible printed circuit board (FPCB) including a driving chip by the pad portion. Here, the driving chip located in the flexible printed circuit board may include various driving circuits for driving the display device 1000, connectors for supplying power, or the like. Depending on the embodiment, instead of the flexible printed circuit board, a rigid printed circuit board (PCB) may be used.

The optical element ES may be located in a lower portion of the display panel DP. The optical element ES may include a first optical element ES1 overlapping with the first component area EA1 and a second optical element ES2 overlapping with the second component area EA2. The first optical element ES1 may use an infrared ray, and at this time, in the first component area EA1, a layer that does not transmit light, such as a light blocking layer, may overlap with the first component area EA1.

The first optical element ES1 may be an electronic element using light or sound. For example, the first optical element ES1 may be a sensor that receives and uses light like an infrared sensor, a sensor that outputs and senses light or sound to measure a distance or recognize fingerprints, a small lamp that outputs light, or a speaker that outputs sound. In the case of electronic elements using light, it is possible to use light of various wavelength bands, such as visible light, infrared rays, and ultraviolet rays.

The second optical element ES2 may be at least one of a camera, an infrared (IR) camera, a dot projector, an infrared (IR) illuminator, and a time-of-flight (ToF) sensor.

Referring to FIG. 3, the display device 1000 may include the display panel DP, a power supply module PM, a first electronic module EM1, and a second electronic module EM2. The display panel DP, the power supply module PM, the first electronic module EM1, and the second electronic module EM2 may be electrically connected to each other. FIG. 3 illustrates, an example configuration of the display panel DP, with the display pixel PX and the touch sensor TS located in the display area DA.

The power supply module PM may supply the power required for overall operation of the display device 1000. The power supply module PM may include a conventional battery module.

The first electronic module EM1 and the second electronic module EM2 may include various types of functional modules for operating the display device 1000. The first electronic module EM1 may be directly mounted on the motherboard electrically connected to the display panel DP, or may be mounted on a separate substrate to be electrically connected to the motherboard through a connector (not shown) or the like.

The first electronic module EM1 may include a control module CM, a wireless communication module TM, an image input module IIM, an audio input module AIM, a memory MM, and an external interface IF. Some of the modules may not be mounted on the motherboard, but may be electrically connected to the motherboard through a flexible printed circuit board connected thereto.

The control module CM may control the overall operation of the display device 1000. The control module CM may be a microprocessor. For example, the control module CM may activate or inactivate the display panel DP. The control module CM may control other modules such as the image input module IIM or the audio input module AIM based on the touch signal received from the display panel DP.

The wireless communication module TM may transmit/receive wireless signals to/from other terminals using Bluetooth or Wi-Fi lines. The wireless communication module TM may transmit/receive voice signals using a general communication line. The wireless communication module TM includes a transmitter TM1 for modulating signals and transmitting the same, and a receiver TM2 for demodulating the received signals.

The image input module IIM may process image signals and may convert them into image data displayable to the display panel DP. The audio input module AIM may receive an external acoustic signal by a microphone in a recording mode or a voice recognition mode and may convert it into electrical voice data.

The external interface IF may serve as an interface connected to an external charger, a wired/wireless data port, a card socket (e.g., a memory card, a SIM/UIM card), etc.

The second electronic module EM2 may include an audio output module AOM, a light emitting module LM, a light receiving module LRM, and a camera module CMM, or the like, at least some of which may be located on the back surface of the display panel DP as optical elements ES, as shown in FIG. 1 and FIG. 2. The optical element ES may include the light emitting module LM, the light receiving module LRM, the camera module CMM, or the like. The second electronic module EM2 may be directly mounted on the motherboard, may be mounted on a separate substrate and electrically connected to the display panel DP through a connector (not shown), or may be electrically connected to the first electronic module EM1.

The audio output module AOM may convert the acoustic data received from the wireless communication module TM or the acoustic data stored in the memory MM, and may output the same to the outside.

The light emitting module LM may generate and output light. The light emitting-module LM may output infrared rays. For example, the light emitting module LM may include a LED element. For example, the light receiving module LRM may sense infrared rays. The light receiving module LRM may be activated when infrared rays above a predetermined level are sensed. The light receiving module LRM may include a CMOS sensor. When the infrared rays generated in the light emitting module LM are output, they may be reflected by an external subject (e.g., the user's finger or face), and the reflected infrared rays may be incident on the light receiving module LRM. The camera module CMM may photograph external images.

In an embodiment, the optical element ES may additionally include an optical sensor or a heat sensor. The optical element ES may sense an external subject received through the front surface or may provide acoustic signals such as voice to the outside through the front surface. In addition, the optical element ES may include a plurality of components, and is not limited to any one embodiment.

Referring back to FIG. 2, the housing HM may be coupled to the cover window WU. The cover window WU may be located on the front surface of the housing HM. The housing HM may be coupled to the cover window WU to provide a predetermined accommodation space. The display panel DP and the optical element ES may be accommodated in the predetermined accommodation space provided between the housing HM and the cover window WU.

The housing HM may contain a material with relatively high rigidity. For example, the housing HM may include glass, plastic, or metal, or may include a plurality of frames and/or plates made of a combination thereof. The housing HM may stably protect the components of the display device 1000 accommodated in the internal space from external impacts.

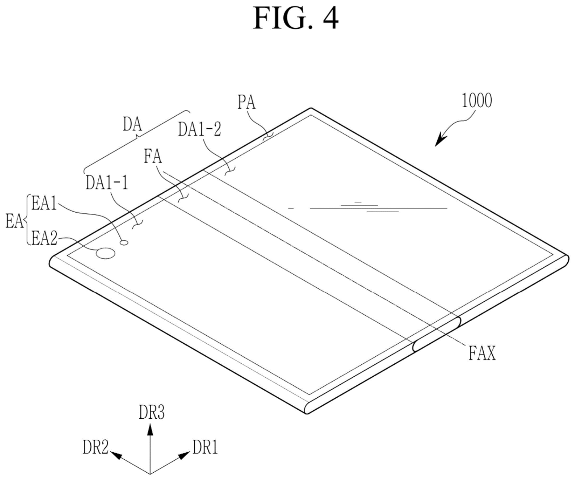

Hereinafter, the structure of the display device 1000 according to an embodiment will be described with reference to FIG. 4.

FIG. 4 is a perspective view schematically showing a light emitting display device 1000 according to an embodiment.

Descriptions of the same configuration as the constituent elements described above will be omitted, and the embodiment of FIG. 4 shows a foldable display device having a structure in which the display device 1000 is folded through a folding axis FAX.

Referring to FIG. 4, in an embodiment, the display device 1000 may be a foldable display device. The display device 1000 may be folded outward or inward based on the folding axis FAX. When folded outward based on the folding axis FAX, the display surface of the display device 1000 may be positioned outwardly in the third direction DR3 so that images may be displayed in both directions. When folded inward based on the folding axis FAX, the display surface may not be visible from the outside.

In an embodiment, the display device 1000 may include the display area DA, the component area EA and the non-display area PA. The display area DA may be divided into a 1-1-th display area DA1-1, a 1-2-th display area DA1-2 and a folding area FA. The 1-1-th display area DA1-1 and the 1-2-th display area DA1-2 may be located to the left and right (or centered on) respectively based on the folding axis FAX, and the folding area FA may be located between the 1-1-th display area DA1-1 and the 1-2-th display area DA1-2. At this time, when folded outward based on the folding axis FAX, the 1-1-th display area DA1-1 and the 1-2-th display area DA1-2 may be located on both sides in the third direction DR3, and may display images in both directions. In addition, when folded inward based on the folding axis FAX, the 1-1-th display area DA1-1 and the 1-2-th display area DA1-2 may not be visible from the outside.

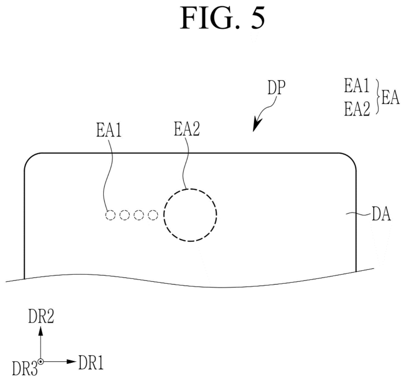

FIG. 5 is an enlarged top plan view of a partial area of a light emitting display device according to an embodiment.

FIG. 5 shows a part of a light emitting display panel DP of a light emitting display device according to an embodiment, by using a display panel for a mobile phone.

The display area DA may be located on the front surface of the light emitting display panel DP, and the component area EA may also be located within the display area DA. Specifically, the component area EA may include the first component area EA1 and the second component area EA2. Additionally, in the embodiment of FIG. 5, the first component area EA1 may be located adjacent to the second component area EA2. In the embodiment of FIG. 5, the first component area EA1 is located on the left side of the second component area EA2. The location and the number of the first component area EA1 may vary depending on embodiments. In FIG. 5, the second optical element ES2 corresponding to the second component area EA2 may be a camera, and the first optical element ES1 corresponding to the first component area EA1 may be a light sensor.

A plurality of light emitting diodes and a plurality of pixel circuit sections for generating light emitting currents and transmitting the same to the light emitting diodes are formed in the display area DA. Here, one light emitting diode and one pixel circuit section are referred to as a pixel. In the display area DA, one pixel circuit section and one light emitting diode are formed one-to-one. Although FIG. 5 does not illustrate the structure of the light emitting display panel DP below the cutting-plane line, the display area DA may be located below the cutting-plane line.

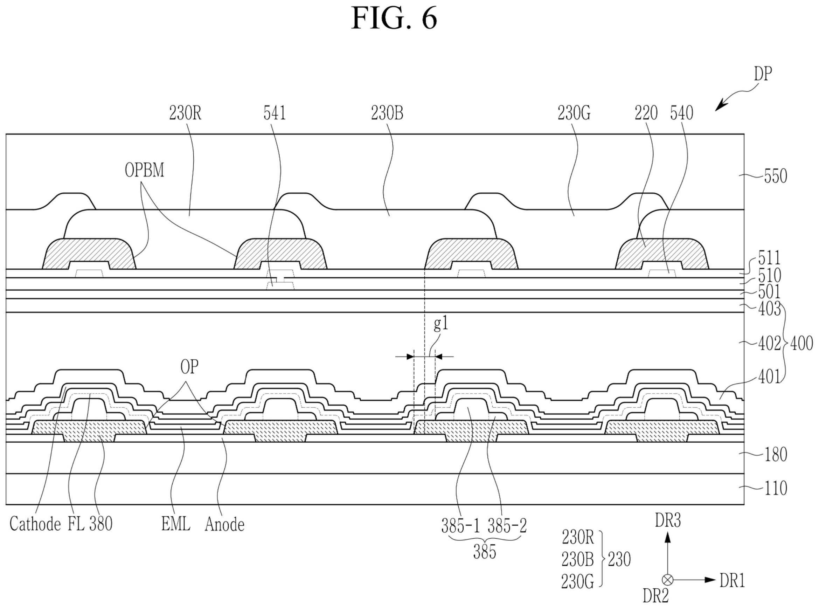

The light emitting display panel DP according to an embodiment may be largely divided into a lower panel layer and an upper panel layer. The lower panel layer may be a portion in which the light emitting diode and the pixel circuit section constituting a pixel are located, and may also include an encapsulation layer 400 (see FIG. 6) covering the same. That is, the lower panel layer spans from a substrate 110 (see FIG. 6) to the encapsulation layer, and may include an anode, a pixel defining layer 380 (see FIG. 6), an emission layer EML (see FIG. 6), a spacer 385 (see FIG. 6), a functional layer FL (see FIG. 6), and a cathode (see "Cathode" in FIG. 6), and may include an insulation layer between the substrate and the anode, a semiconductor layer, and a conductive layer. The upper panel layer is a portion located in an upper portion of the encapsulation layer, may include sensing insulation layers 501, 510, and 511 (see FIG. 6) capable of sensing touches and a plurality of sensing electrodes 540 and 541 (see FIG. 6), and may include a light blocking layer 220 (see FIG. 6), a color filter 230 (see FIG. 6), and a planarization layer 550 (see FIG. 6), or the like.

The first component area EA1 may be configured to only include a transparent layer to allow light to pass through, and may not include the conductive layer or the semiconductor layer to enable light to pass through, and may have a structure in which a photosensor area is formed in the lower panel layer, and the opening (hereinafter, also referred to as an additional opening) is formed at a location corresponding to the first component area EA1, the pixel defining layer, the light blocking layer, and a color filter layer of the upper panel layer, so that light is not blocked. In an embodiment, even if the photosensor area is located in the lower panel layer and there is no corresponding opening in the upper panel layer, it may be the display area DA and not the first component area EA1. One first component area EA1 may include a plurality of adjacent photosensor areas, and at this time, the pixel adjacent to the photosensor area may be included in the first component area EA1. In an embodiment, in the case that the first optical element ES1 corresponding to the first component area EA1 uses infrared rays rather than visible rays, the first component area EA1 may overlap with the light blocking layer 220 that blocks visible rays.

The second component area EA2 may include the second component pixel and the light transmitting area, and a space between adjacent second component pixels may be the light transmitting area.

Although not shown in FIG. 5, a peripheral area may be further located outside the display area DA. In addition, although FIG. 5 shows a display panel for a mobile phone, the present embodiment may be applied when the optical element can be located on the back surface of the display panel, and it may be a flexible display device. In the case of a foldable display device among flexible display devices, positions of the second component area EA2 and the first component area EA1 may be formed at a different location from FIG. 5.

Hereinafter, a structure of the light emitting display panel DP according to an embodiment will be described with reference to FIG. 6.

FIG. 6 is a schematic cross-sectional view of a display panel according to an embodiment.

The light emitting display panel DP according to an embodiment may display an image by forming light emitting diodes on the substrate 110, may sense touches by including the plurality of sensing electrodes 540 and 541, and may provide color characteristics of the color filters 230R, 230G, and 230B to the light emitted from the light emitting diode by including the light blocking layer 220 and the color filters 230R, 230G, and 230B.

In addition, a polarizing plate is not formed on the front surface of the light emitting display panel DP according to an embodiment, and instead, the pixel defining layer 380 is formed of a black organic material while forming the light blocking layer 220 and the color filter 230 in the upper portion, so that even if external light enters the inside, it may be reflected from an anode Anode or the like and may not be transferred to the user. In addition, since the polarizing plate is not formed, the brightness is not lowered as the light emitted from the emission layer is partially absorbed by the polarizing plate, and the light emitting display device with the maximum brightness value of 2500 nits or more may be provided.

The light emitting display panel DP according to an embodiment will be described in detail, as follows.

The substrate 110 may include a material that does not bend due to rigid characteristics such as glass, or may include a flexible material that can be bent such as plastic or polyimide.

Although a plurality of thin-film transistors are formed on the substrate 110, FIG. 6 only illustrates an organic layer 180 covering the thin-film transistors, without showing them. A pixel has a light emitting diode and a pixel circuit section in which a plurality of transistors and capacitors configured to transfer light emitting currents to the light emitting diodes are formed. FIG. 6 does not illustrate the pixel circuit section, and the structure of the pixel circuit section may vary according to the embodiment. In FIG. 6 the organic layer 180 covering the pixel circuit section is shown.

The light emitting diode including the anode Anode, the emission layer EML, and the cathode Cathode may be located on the organic layer 180.

The anode Anode may be formed as a single layer including a transparent conductive oxide layer and a metal material or multiple layers including the same. The transparent conductive oxide layer may include indium tin oxide (ITO), poly-ITO, indium zinc oxide (IZO), indium gallium zinc oxide (IGZO) and indium tin zinc oxide (ITZO), or the like, and the metal material may include silver (Ag), molybdenum (Mo), copper (Cu), gold (Au) and aluminum (Al), or the like.

The emission layer EML may be formed of an organic light emitting material, and the adjacent emission layers EML may display different colors. Depending on the embodiment, the respective emission layers EML may display light of the same color due to the color filters 230R, 230G, and 230B located in the upper portion. Depending on the embodiment, the emission layer EML may have a structure in which a plurality of emission layers are stacked (also referred to as a tandem structure).

The pixel defining layer 380 may be located on the organic layer 180 and the anode Anode, the pixel defining layer 380 may be formed with an opening OP (hereinafter, also referred to as a first opening), the opening OP may extend to and overlap with a part of the anode Anode, and the emission layer EML may be located on the anode Anode exposed by the opening OP. The emission layer EML may be located only within the opening OP of the pixel defining layer 380, and may be separated from the adjacent emission layer EML by the pixel defining layer 380.

The pixel defining layer 380 may be formed of a negative-type black organic material. A black organic material may include a light blocking layer, and the light blocking layer may include a resin or a paste including carbon black, carbon nanotube, and black dye, a metal particle-for example, nickel, aluminum, molybdenum, and alloys thereof-and a metal oxide particle (e.g., chromium nitride), or the like. The pixel defining layer 380 may include a light blocking layer, may have a black color, and may have the characteristic of absorbing/blocking light rather than reflecting it. Since the negative-type organic material is used, it may have the characteristic of removing a portion covered by the mask.

The spacer 385 is formed on the pixel defining layer 380. The spacer 385 includes a first portion 385-1 located in a tall and narrow area and a second portion 385-2 located in a low and wide area. FIG. 6 shows that the first portion 385-1 and the second portion 385-2 are separated through a dotted line in the spacer 385. Here, the first portion 385-1 may serve to secure rigidity against a pressing pressure by enhancing scratch resistance. The second portion 385-2 may serve as a contact aid between the pixel defining layer 380 and the upper functional layer FL. The first portion 385-1 and the second portion 385-2 may be formed of the same material, and may be formed of a positive-type photosensitive organic material. For example, a photosensitive polyimide (PSPI) may be used. Since it has a positive characteristic, the portion not covered by the mask may be removed. The spacer 385 has transparency so that light may be transmitted and/or reflected.

The pixel defining layer 380 may be formed in a negative type, the spacer 385 may be formed in a positive type, and they may include similar materials depending on the embodiment.

At least a portion of an upper surface of the pixel defining layer 380 may be covered by the spacer 385, and an edge of the second portion 385-2 is spaced apart from an edge of the pixel defining layer 380, so that a part of the pixel defining layer 380 is not covered by the spacer 385. The second portion 385-2 may cover the upper surface of the pixel defining layer 380, on which the first portion 385-1 is not located, and may increase an adhesive characteristic between the pixel defining layer 380 and the functional layer FL. In the present embodiment, the spacer 385 is located only in the area overlapping with the light blocking layer 220 in a plan view to be described later, so that the spacer 385 may be covered by the light blocking layer 220 and may be invisible when viewed from the front surface of the display panel DP.

The functional layer FL is located on the spacer 385 and the exposed pixel defining layer 380, and the functional layer FL may be formed on the front surface of the light emitting display panel DP, or may be formed entirely over the area excluding a partial area-e.g., the light transmitting area of the second component area EA2. The functional layer FL may include an electron injection layer (EIL), an electron transport layer, a hole transport layer, and a hole injection layer (HIL), and the functional layer FL may be located above and below the emission layer EML. That is, the hole injection layer, the hole transport layer, the emission layer EML, the electron transport layer, the electron injection layer, and the cathode Cathode may be sequentially located on the anode Anode, so that, among the functional layers FL, the hole injection layer and the hole transport layer may be located in a lower portion of the emission layer EML, and the electron transport layer and the electron injection layer may be located in an upper portion of the emission layer EML.

The spacer 385 increases the scratch resistance on the light emitting display panel DP to lower occurrence rate of defects due to the pressing pressure, and depending on the embodiment, may increase the adhesive strength with respect to the functional layer FL located in an upper portion of the spacer 385, so that moisture and air may not be injected from the outside. In addition, high adhesive strength has the merit of eliminating the problem of decrease of adhesive strength between layers when the light emitting display panel DP has a flexible characteristic, and folds and unfolds.

The cathode Cathode may be formed of a light transmitting electrode or a reflecting electrode. Depending on the embodiment, the cathode Cathode may be a transparent or semi-transparent electrode, and may be formed in a metal thin film with a small work function, including lithium (Li), calcium (Ca), fluorinated lithium/calcium (LiF/Ca), fluorinated lithium/aluminum (LiF/Al), aluminum (Al), silver (Ag), magnesium (Mg) and compounds thereof. In addition, a transparent conductive oxide (TCO) layer such as indium tin oxide (ITO), indium zinc oxide (IZO), zinc oxide (ZnO) or oxidation indium (In₂O₃) may be further located on the metal thin film. The cathode Cathode may be integrally formed over the front surface of the light emitting display panel DP.

The encapsulation layer 400 may be located on the cathode Cathode. The encapsulation layer 400 may include at least one inorganic layer and at least one organic layer, and FIG. 6 shows a triple-layer structure that includes a first inorganic encapsulation layer 401, an organic encapsulation layer 402, and a second inorganic encapsulation layer 403. The encapsulation layer 400 may protect the emission layer EML made of an organic material from moisture or oxygen that may be introduced from the outside. Depending on the embodiment, the encapsulation layer 400 may include a structure in which an inorganic layer and an organic layer are sequentially further stacked.

On the encapsulation layer 400, the sensing insulation layers 501, 510, and 511 and the plurality of sensing electrodes 540 and 541 may be located to sense touches. In the embodiment of FIG. 6, although touch is sensed in a capacitive type by using the two sensing electrodes 540 and 541, depending on the embodiment, touch may be sensed in a self-cap method by using only one sensing electrode. The plurality of sensing electrodes 540 and 541 may be insulated interposing the second sensing insulation layer 510, the lower sensing electrode 541 may be located on the first sensing insulation layer 501, the upper sensing electrode 540 may be located on the second sensing insulation layer 510, and the upper sensing electrode 540 is covered by the third sensing insulation layer 511. The plurality of sensing electrodes 540 and 541 may be electrically connected through the opening located in the second sensing insulation layer 510. Here, the sensing electrodes 540 and 541 may include a metal such as aluminum (Al), copper (Cu), silver (Ag), gold (Au), molybdenum (Mo), titanium (Ti), tantalum (Ta), or the like, or a metal alloy thereof, and may be formed in a single layer or in multiple layers.

The light blocking layer 220 and the color filters 230R, 230G, and 230B may be located on the third sensing insulation layer 511.

The light blocking layer 220 may be located to overlap with the sensing electrodes 540 and 541 in a plan view, and may be located not to overlap with the anode Anode in a plan view. This is to prevent the anode Anode and the emission layer EML that can display images from being blocked by the light blocking layer 220 and the sensing electrodes 540 and 541.

Referring to FIG. 6, the light blocking layer 220 may be located only in an area overlapping with the pixel defining layer 380 in a plan view, and one side of the light blocking layer 220 is located inward from a corresponding side of the pixel defining layer 380.

The light blocking layer 220 may also have a second opening OPBM (hereinafter, also referred to as a second opening), an area of the second opening OPBM of the light blocking layer 220 may be formed to be larger than the opening OP of the pixel defining layer 380, and in a plan view, the opening OP of the pixel defining layer 380 may be located within the second opening OPBM of the light blocking layer 220.

In addition, one side of the spacer 385 is located inward from a corresponding side of the pixel defining layer 380 by a preset interval g1, and the spacer 385 is located inward from one side of the light blocking layer 220. As a result, when viewed from the front surface of the display panel DP, the spacer 385 may not be visible due to the light blocking layer 220.

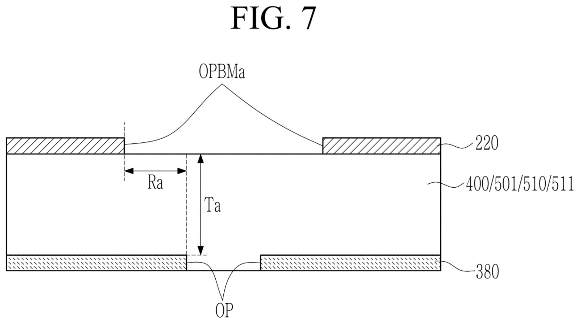

When external light is incident, it may pass through the second opening OPBM of the light blocking layer 220, and then may be reflected from the side wall of the opening OP of the pixel defining layer 380. The side wall of the opening OP of the pixel defining layer 380 may form a curved surface, so that color separation occurs depending on the reflected position, and thereby the color of the reflection light may appear as a rainbow of colors. Furthermore, when at least one of the openings OP and OPBM is formed to be elliptical to have directionality, the degree of reflection of the external light may vary depending on angles, so that periodic stains may be visible depending on the angle. Since such color-separated reflection light or a stain phenomenon may be easily noticeable to the user's eye and may degrade the display quality, the minimum number of unit pixels included in repeated unit pixels repeatedly formed in the display area may be reduced to, for example, 2x2 or the like, or the sum of the reflection average of the external light over angles is formed to be similar within a certain range, so that the difference of the reflective ratio of the external light may not be visible by the user. In addition, each of the second opening OPBM of the light blocking layer 220 and the opening OP of the pixel defining layer 380 may be formed in an elliptical shape, and the direction of the elliptical shape or the eccentricity of the elliptical shape may be diversely arranged so that color separation may be reduced or the white reflected light may be visible. This will be described in more detail with reference to FIG. 7.

The color filters 230R, 230G, and 230B may be located on the sensing insulation layers 501, 510, and 511 and the light blocking layer 220. The color filters 230R, 230G, and 230B may include a red color filter 230R transmitting red light, a green color filter 230G transmitting green light, and a blue color filter 230B transmitting blue light. Each of the color filters 230R, 230G, and 230B may be located to overlap with the anode Anode of the light emitting diode in a plan view, and the color filters 230R, 230G, and 230B of one color may be filled within the second opening OPBM of the light blocking layer 220. A portion of the color filters 230R, 230G, and 230B may also be located on an upper surface of the light blocking layer 220. As the light emitted from the emission layer EML may pass through a color filter to be changed to a corresponding color and then be emitted, all light emitted from the emission layer EML may have the same color. However, the emission layer EML may display light of different colors, and may allow the light to pass through a color filter of the same color, to strengthen the displayed color.

The light blocking layer 220 may be located between the color filters 230R, 230G, and 230B. Depending on the embodiment, the color filters 230R, 230G, and 230B may be replaced with color conversion layers, or may further include color conversion layers. The color conversion layer may include quantum dots.

The planarization layer 550 covering the color filters 230R, 230G, and 230B may be located on the color filters 230R, 230G, and 230B. The planarization layer 550 may be employed to planarize an upper surface of the light emitting display panel, and may be a transparent organic insulator including one or more materials selected from a group consisting of a polyimide, a polyamide, an acryl resin, benzocyclobutene, and a phenol resin.

Depending on the embodiment, in order to improve the frontal visibility and light emission efficiency of the display panel, a low-refractive layer and an additional planarization layer may be further located on the planarization layer 550. By the low-refractive layer and the additional planarization layer having a high refractive characteristic, light may be emitted while being refracted to the front surface. In this case, depending on the embodiment, since the planarization layer 550 is omitted, a low-refractive layer and an additional planarization layer may be located on the color filter 230.

In the present embodiment, a polarizing plate is not included in an upper portion of the planarization layer 550. That is, the polarizing plate may serve to prevent external light from entering and being reflected from the anode Anode or the side wall of the opening OP of the pixel defining layer 380, for example, degrading the display quality as seen by the user. However, the polarizing plate not only reduces the reflection of the external light but also reduces light emitted from the emission layer EML, so that more electrical power must be consumed in order to display a preset brightness. In order to reduce power consumption, the light emitting display device of the present embodiment may not include a polarizing plate. In addition, in the light emitting display device of the present embodiment, since the polarizing plate is not formed, the brightness is not lowered as the light emitted from the emission layer is partially absorbed by the polarizing plate, and a light emitting display device with the maximum brightness value of 2500 nits or more may be provided.

In addition, the present embodiment already includes the structure in which the degree of reflection from the anode Anode is reduced by covering a side surface of the anode Anode by the pixel defining layer 380, and the degree of incident light is reduced by forming the light blocking layer 220, so that the degradation of display quality due to reflection is prevented. Therefore, the polarizing plate may not be separately formed on the front surface of the light emitting display panel DP.

The plurality of pixels may be located in the display area DA of the light emitting display device to display images, and one pixel may include at least two of red (R), green (G), and blue (B) subpixels. The display area DA includes a minimum unit pixel including red (R), green (G), and blue (B) subpixels, each by at least one, and the minimum unit pixel may have an elliptical shape with a different eccentricity and/or major axis direction of the ellipse from the openings OP and OPBM corresponding to the adjacent minimum unit pixel. In addition, the minimum unit pixel may be located within a square or a similar area in the display area DA. A plurality of minimum unit pixels may be included to form the repeated unit pixels, and the repeated unit pixels may be formed by being repeated within an entire area of the display area DA. The repeated unit pixels may have an elliptical shape with the same eccentricity and major axis direction of the ellipse as the openings OP and OPBM corresponding to the adjacent repeated unit pixels. The repeated unit pixels may also be located within a square or a similar area in the display area DA, but may have a larger area than the area in which the minimum unit pixel is formed.

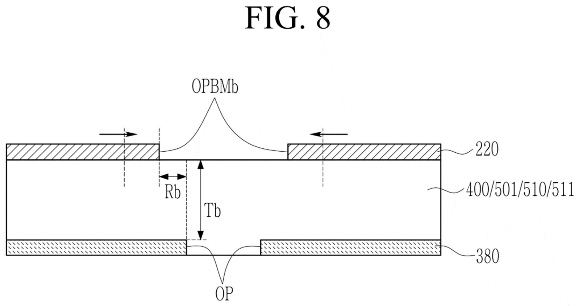

Hereinafter, the features of the edge area will be described through a portion of the normal center pixel located in the central area and a portion of the edge pixel located in the edge area among the display area DA with reference to FIG. 7 and FIG. 8.

FIG. 7 is a cross-sectional view showing the second opening in the central area in a normal display area according to an embodiment, and FIG. 8 is a cross-sectional view showing the second opening in the edge area in a normal display area according to an embodiment.

FIG. 7 and FIG. 8 illustrate the pixel defining layer 380, the light blocking layer 220, and light emitting element cover insulation layers 400/501/510/511, located therebetween, among the cross-section structures of FIG. 6. The light emitting element cover insulation layers 400/501/510/511 according to the embodiment of FIG. 6 may include the encapsulation layer 400, the first sensing insulation layer 501, the second sensing insulation layer 510, and the third sensing insulation layer 511. In addition, the pixel defining layer 380 may have the opening OP overlapping with the emission layer EML (see FIG. 6) in a plan view, and the light blocking layer 220 may have central second openings OPBMa and OPBMb overlapping with the opening OP of the emission layer and/or the pixel defining layer 380 in a plan view.

The normal center pixel located in the central area shown in FIG. 7 and the edge pixel located in the edge area shown in FIG. 8 may have the same structure up to the pixel defining layer 380, in which case the size and/or shape of the opening OP may also be the same for the same color.

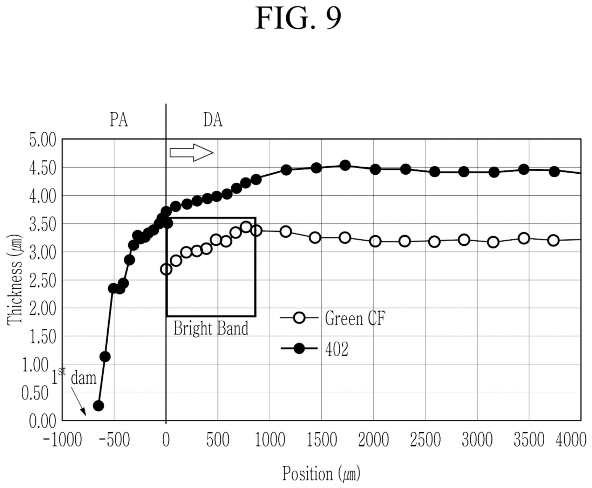

The light emitting element cover insulation layers 400/501/510/511 may have a height Ta that is uniform entirely over the central area, and the edge area may have a height Tb that is lower than the central area. This may be because at least one insulation layer of a plurality of insulation layers included in the light emitting element cover insulation layers 400/501/510/511 has lower heights toward the non-display area PA (see FIG. 9). Depending on the embodiment, at least one of the organic layers included in the light emitting element cover insulation layers 400/501/510/511 may have lower heights toward the non-display area PA, and in the embodiment of FIG. 6, may be the organic encapsulation layer 402 included in the encapsulation layer 400.

As the height of the light emitting element cover insulation layers 400/501/510/511 is lowered, an interval between the pixel defining layer 380 and the light blocking layer 220 becomes narrower. The emission layer emits light through the opening OP of the pixel defining layer 380 and the second openings OPBMa and OPBMb of the light blocking layer 220, and when the interval between the pixel defining layer 380 and the light blocking layer 220 is narrowed, the angle of emitting light increases, which can increase the lateral brightness ratio of the edge area may be increased or cause light leakage. Therefore, when the size of the second opening OPBMb (hereinafter, referred to as an edge second opening) of the light blocking layer 220 corresponding to the edge pixel is formed to be the same as the size of the second opening OPBMa (hereinafter, referred to as a central second opening) of the light blocking layer 220 corresponding to the center pixel, it may be brighter in various angles or the bright band phenomenon (see FIG. 9) may occur. However, in an embodiment, the edge second opening OPBMb is formed to be smaller than the central second opening OPBMa. In addition, in an embodiment, a horizontal distance Rb from a boundary of the opening OP of the pixel defining layer 380 to a boundary of the edge second opening OPBMb may be formed to be smaller than a horizontal distance Ra from the boundary of the opening OP of the pixel defining layer 380 to a boundary of the central second opening OPBMa, to prevent the bright band phenomenon. At this time, depending on the embodiment, the opening OP of the pixel defining layer 380 and the second openings OPBMa and OPBMb of the light blocking layer 220 may have the same planar shape, and may have the same horizontal distance in all directions in a plan view.

The edge area is an area in which the height of the light emitting element cover insulation layers 400/501/510/511 is low compared to the central area, and the edge area may be located within a range of about 3 mm or less inward from the outermost edge of the display area DA. Depending on the embodiment, the width of the edge area may be narrower.

Depending on the embodiment, when the height in the edge area of the light emitting element cover insulation layers 400/501/510/511 becomes lower than the height in the central area by about 1 µm, the horizontal distance Rb from the boundary of the opening OP of the pixel defining layer 380 to the boundary of the edge second opening OPBMb may become narrower than the horizontal distance Ra from the boundary of the opening OP of the pixel defining layer 380 to the boundary of the central second opening OPBMa by about 0.5 µm. Accordingly, according to the heights of the various light emitting element cover insulation layers 400/501/510/511, the edge second opening having a plurality of horizontal distances Rb may be formed in the edge area.

Depending on the embodiment, the horizontal distance Rb of the second opening may be adjusted based on the angle at which the brightness of the light emitting display device from the side is 100% of that from the front (hereinafter, also referred to as a side viewing angle). At this time, when the height of the light emitting element cover insulation layers 400/501/510/511 decreases by about 4.25 µm in the light emitting display device having the side viewing angle of 40 degrees, the horizontal distance Rb from the boundary of the opening OP of the pixel defining layer 380 to the boundary of the edge second opening OPBMb may become narrower than the horizontal distance Ra from the boundary of the opening OP of the pixel defining layer 380 to the boundary of the central second opening OPBMa by about 1.94 µm.

Hereinafter, the thickness change in an edge of the organic encapsulation layer 402 included in the light emitting element cover insulation layer will be described with reference to FIG. 9.

FIG. 9 is a graph showing the thickness change of the organic encapsulation layer and the color filter in a display panel according to an embodiment.

In FIG. 9, the relative positions of the display area DA and the non-display area PA are indicated as plus and minus, respectively, based on the outermost edge of the display area DA. In addition, FIG. 9 shows a thickness of the organic encapsulation layer 402 and green color filter (green CF) at each location.

Referring to FIG. 9, in the embodiment, it can be confirmed that the thickness of the organic encapsulation layer 402 is rapidly decreased from around 1000 µm-i.e., around 1 mm-and that the first dam (1^{st} dam) that prevents the organic material from overflowing from the non-display area PA is formed.

In FIG. 9, the thickness of the green color filter (Green CF) is also shown, and the thickness of the green color filter (Green CF) was investigated only in the display area (DA). Depending on the embodiment, the material of the green color filter (green CF) may also be located in the non-display area PA.

Referring to FIG. 9, it can be confirmed that the thickness of the green color filter (Green CF), which is one of the color filters located in front of the light emitting element cover insulation layer, also decreases. This is because the thickness of the organic encapsulation layer 402 decreases toward the edge, and the color filter formed thereon also flows toward the edge and becomes thinner.

As such, since the color filter located on the front surface of the light emitting element cover insulation layer also decreases in height in the edge area, the light emitted from the emission layer is less filtered and transmitted, so that the lateral brightness ratio of the edge area increases, causing a phenomenon such as light leakage or a bright band phenomenon to be observed. In addition, even when light is not emitted from the emission layer, the bright band phenomenon may occur as the reflection of external light increases.

In the embodiment of FIG. 9, the bright band phenomenon occurs in a range of about 1 mm or less, so the edge area may have a width of about 1 mm.

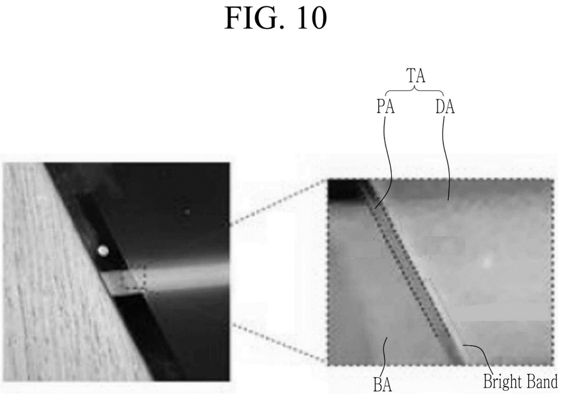

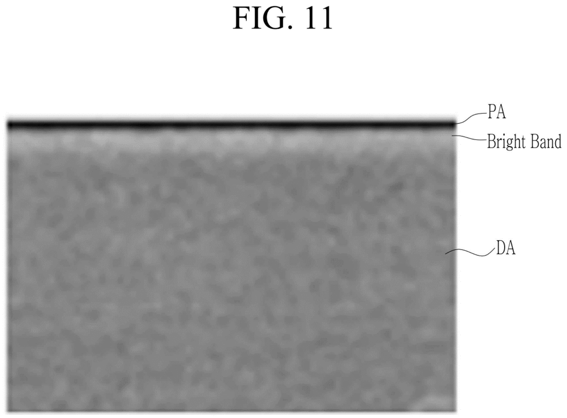

Hereinafter, a problem that may occur in the edge area of the display panel of Comparative Example will be described with reference to FIG. 10 and FIG. 11.

FIG. 10 and FIG. 11 are drawings showing the bright band phenomenon of the edge area in the display panel of the Comparative Example.

First, FIG. 10 is a drawing of a photograph taken in a state in which external light is applied to the light emitting display device of the Comparative Example in an Off-state in which pixels does not emit light, and particularly, the right side of FIG. 10 shows a photograph of a portion of the light emitting display device to which external light is applied.

The enlarged drawing of FIG. 10 is a portion of an area where external light is reflected, where the blocking area BA and the transmitting area TA of the light emitting display device are photographed, and the transmitting area TA also corresponds to the display area DA and a portion of the non-display area PA of the light emitting display panel. In may be confirmed that, among them, external light is reflected more brightly in an edge portion of the display area DA so a bright band is visible.

FIG. 11 shows a photograph of a partial area of the light emitting display device of the Comparative Example in an On-state in which pixels emit light. Referring to FIG. 11, it may be confirmed that a bright band having a relatively brighter brightness is visible in the edge area located in the edge portion of the display area DA.

Unlike FIG. 10 and FIG. 11, in a light emitting display device according to an embodiment, as in FIG. 8, the edge second opening OPBMb located in the edge area may be formed to be smaller than the central second opening OPBMa, or the horizontal distance Rb from the boundary of the opening OP of the pixel defining layer 380 to the boundary of the edge second opening OPBMb may be formed to be smaller than the horizontal distance Ra from the boundary of the opening OP of the pixel defining layer 380 to the boundary of the central second opening OPBMa, so that the bright band phenomenon does not appear.

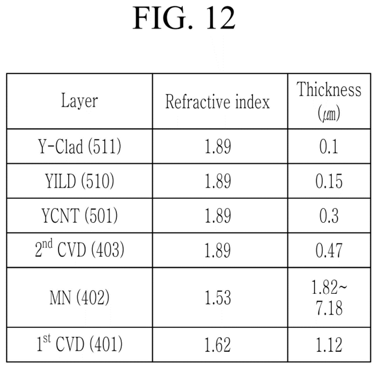

Hereinafter, a method for determining how much the edge second opening OPBMb located in the edge area is to be reduced compared to the central second opening OPBMa will be described with reference to FIG. 12 to FIG. 15.

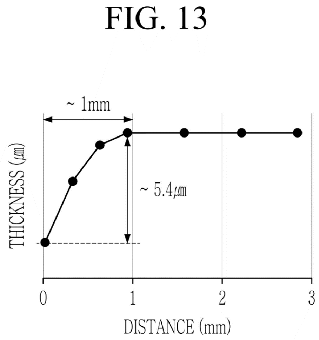

First, the stacking structure of the light emitting element cover insulation layer and the thickness change of the organic encapsulation layer of a display panel according to an embodiment will be described with reference to FIG. 12 and FIG. 13.

FIG. 12 is a table showing the light emitting element cover insulation layer in a display panel according to an embodiment, and FIG. 13 is a graph showing the thickness change of the organic encapsulation layer in a display panel according to an embodiment.

Referring to FIG. 12, the light emitting element cover insulation layer may include an encapsulation layer including the first inorganic encapsulation layer 401, the organic encapsulation layer 402 and the second inorganic encapsulation layer 403, the first sensing insulation layer 501, the second sensing insulation layer 510, and the third sensing insulation layer 511. As shown in FIG. 12, the first inorganic encapsulation layer 401 may have a refractive index of 1.62, the organic encapsulation layer 402 may have a refractive index of 1.53, and the second inorganic encapsulation layer 403, the first sensing insulation layer 501, the second sensing insulation layer 510, and the third sensing insulation layer 511 may all have a refractive index of 1.89. In addition, the first inorganic encapsulation layer 401 may have a thickness of about 1.12 µm, the organic encapsulation layer 402 may have a thickness of about 1.82 µm to about 7.18 µm, the second inorganic encapsulation layer 403 may have a thickness of about 0.47 µm, the first sensing insulation layer 501 may have a thickness of about 0.3 µm, the second sensing insulation layer 510 may have a thickness of about 0.15 µm, and the third sensing insulation layer 511 may have a thickness of about 0.1 µm. Here, the organic encapsulation layer 402 has a uniform thickness in the central area of the display area, but its height may decrease toward the outer side, in the edge area and the non-display area. FIG. 13 illustrates a graph of a thickness change of the organic encapsulation layer 402.

FIG. 13 illustrates the thickness change of the organic encapsulation layer 402 in the display area, and the thickness of the organic encapsulation layer 402 according to the distance from the outermost edge of the display area.

Referring to FIG. 13, the thickness change of the organic encapsulation layer 402 only occurs within a range of about 1 mm, and therefore, the width of the edge area may be about 1 mm.

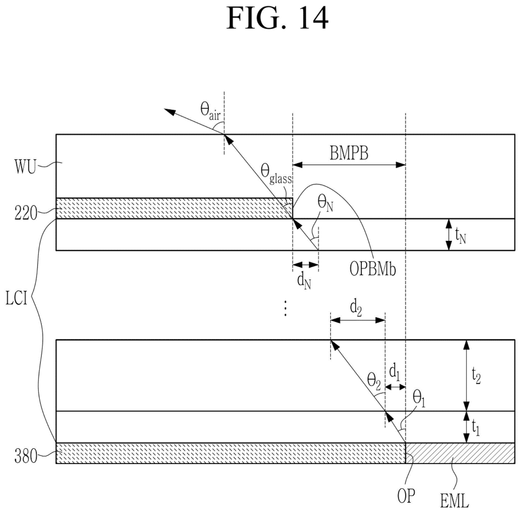

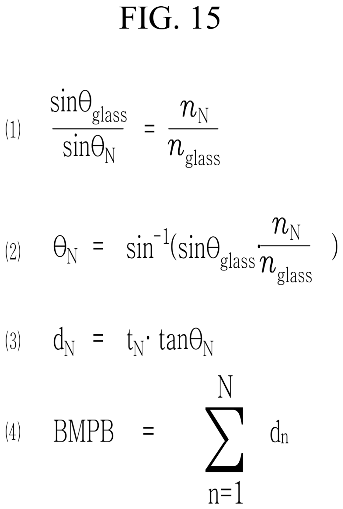

In consideration of the stacking structure and thickness change of the light emitting element cover insulation layer and the direction in which light is emitted in the manner of FIG. 14 and FIG. 15 in the light emitting display device having the features of FIG. 12 and FIG. 13, the size of the edge second opening and/or the horizontal distance from the boundary of the opening of the pixel defining layer 380 to the boundary of the edge second opening may be adjusted.

FIG. 14 and FIG. 15 are drawings showing a method for calculating a path of light provided from the emission layer.

First, in FIG. 14, assuming that N layers are stacked as a light emitting element cover insulation layer LCI, the angle at which the light emitted from the emission layer is bent is calculated by applying Snell's law to each boundary of layers, and a final propagation angle θₐᵢᵣ of light is illustrated by taking the cover window WU into consideration. In FIG. 14, θ represents the angle at which light is bent and propagates, d represents the horizontal distance by which light propagates in the corresponding layer, and t represent a thickness of the corresponding layer. In addition, the subscripts are natural numbers from 1 to N, representing each insulation layer. That is, 1 represents the insulation layer located lowermost, 2 represents the insulation layer located at the second position, and N represents the insulation layer located at the N-th position. In FIG. 14, the propagation angle of the light emitted from the emission layer when leaving the light emitting element cover insulation layer LCI is shown as θ_{glass}, which corresponds to the propagation angle of light in the cover window WU, and the refractive index of the cover window WU may be n_{glass}. The refractive index in an air layer may be nₐᵢᵣ. In FIG. 14, the horizontal distance from the boundary of the opening OP of the pixel defining layer 380 to the boundary of the edge second opening OPBMb is shown as a horizontal distance BMPB, and it may be seen that a value of the horizontal distance BMPB between two openings is a sum value of horizontal distances d₁, d₂, ..., d_{N} by which light has propagated in each layer included in the light emitting element cover insulation layer LCI.

Equation (1) of FIG. 15 is an equation according to Snell's law between the uppermost layer (N-th layer) among the light emitting element cover insulation layers LCI and a layer (the cover window WU in FIG. 14) thereon.

Equation (2) of FIG. 15 is an equation obtained by converting Equation (1) of FIG. 15 into an equation for a propagation angle θ_{N} of light in N-th layer.

Equation (3) of FIG. 15 is an equation representing the relationship between the thickness t_{N} and the horizontal distance d_{N} by which light has propagated in the N-th layer in FIG. 14.

Equation (4) of FIG. 15 mathematically expresses that the horizontal distance BMPB from the boundary of the opening OP of the pixel defining layer 380 to the boundary of the edge second opening OPBMb is the sum value of the horizontal distances d₁, d₂, ..., d_{N} by which light has propagated in each N layer included in the light emitting element cover insulation layer LCI in in FIG. 14.

By using the horizontal distance BMPB from the boundary of the opening OP of the pixel defining layer 380 to the boundary of the edge second opening OPBMb calculated in the sequence of FIG. 15, the size of the edge second opening OPBMb in the edge area may be adjusted.

Although Snell's law was applied only for the light emitting element cover insulation layer LCI and the cover window WU in FIG. 15, depending on the embodiment, the air layer located on the outer side of the cover window WU may also be taken into consideration. In addition, depending on the embodiment, a separate insulation layer may be located between the light emitting element cover insulation layer LCI and the cover window WU, and Snell's law may also be applied to a corresponding insulation layer.

Referring to FIG. 13, since the thickness of the organic encapsulation layer included in the light emitting element cover insulation layer changes depending on positions in the edge area, the horizontal distance and/or size of the edge second opening from the boundary of the opening of the pixel defining layer to the boundary of the edge second opening in the edge area may also be changed depending on location.

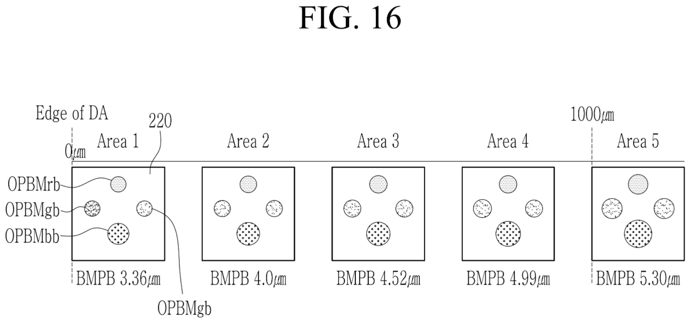

Hereinafter, each of two embodiments in which areas are divided based on the distance from the edge will be described with reference to FIGS. 16 and 17 and FIGS. 18 and 19.

In the embodiment below, the edge area may be divided into a plurality of areas, and edge second openings located in the same area among the plurality of areas and corresponding to the same color pixel may have the same size and/or the same horizontal distance. Among the plurality of areas of the edge area, the edge second opening of an area located close to the outermost edge of the display area is smallest, the edge second opening of an area farthest from the outermost edge of the display area is largest, and the edge second opening in areas located sequentially inward from the outermost edge of the display area may gradually increase.

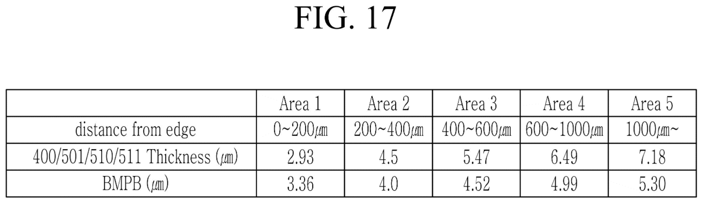

First, FIG. 16 and FIG. 17 will be hereinafter described.

FIG. 16 is a drawing showing a change of the second opening in a display panel according to an embodiment, and FIG. 17 is a table summarizing sizes depending on positions of the second opening according to the embodiment of FIG. 16.

FIG. 16 illustrates an embodiment of a structure in which four pixels form one unit pixel. In the embodiment of FIG. 16, one unit pixel may include one red pixel, one blue pixel, and two green pixels, and in FIG. 16, a red second opening OPBMrb corresponding to the red pixel, a blue second opening OPBMbb corresponding to the blue pixel, and a green second opening OPBMgb corresponding to the green pixel are illustrated differently. The second openings OPBMrb, OPBMgb, and OPBMbb have a circular planar shape, and have different sizes for each color. The first opening (not shown) of the pixel defining layer 380 corresponding to each of the second openings OPBMrb, OPBMgb, and OPBMbb may have different sizes for each color, and the first opening and the second openings OPBMrb, OPBMgb, and OPBMbb corresponding to each other may have centers at the same position in a plan view. Among the plurality of areas of the edge area, the first opening and/or the second opening located in the same area and corresponding to different colors may have different sizes. In the embodiment of FIG. 16, although the first opening and the second opening have circular planar shapes, depending on the embodiment, they may have various shapes such as an ellipse and a polygon.

In FIG. 16, the areas are divided into five areas Area 1, Area 2, Area 3, Area 4, and Area 5, depending on the distance from an outermost edge of the display area DA. The five areas Area 1, Area 2, Area 3, Area 4, and Area 5, may all correspond to the display area DA, the first to fourth areas Area 1 to Area 4 may correspond to the edge area, the fifth area Area 5 may correspond to the central area, and the central area may have the same overall structure as the fifth area Area 5. In the embodiment of FIG. 16, the edge area may be a width of about 1 mm from the edge.

The five areas Area 1, Area 2, Area 3, Area 4, and Area 5, shown in FIG. 16 each have different sized second openings, and the pixels of the same color in the same area may have the same sized second openings.

In FIG. 17, the characteristics of each area in the embodiment of FIG. 16 are shown in a table.

In FIG. 17, the position of each area is distinguished based on the distance from the edge, and a representative thickness of the light emitting element cover insulation layers 400/501/510/511 of each area, and the horizontal distance BMPB from the boundary of the opening OP of the pixel defining layer 380 to the boundary of the edge second opening OPBMb in a corresponding area is also shown. In one area, all the edge second openings OPBMb may have the same horizontal distance BMPB.

Referring to the embodiment of FIG. 17, the first area Area 1 is an area about 200 µm from the edge, a thickness of the light emitting element cover insulation layers 400/501/510/511 may have a thickness of about 2.93 µm, and the horizontal distance BMPB from the boundary of the opening OP of the pixel defining layer 380 to the boundary of the edge second opening OPBMb may be about 3.36 µm. Depending on the embodiment, in the first area Area 1, the horizontal distance BMPB may be smaller, and depending on the embodiment, the horizontal distance BMPB may be about 2.85 µm.

A second area Area 2 is an area from about 200 µm to about 400 µm from the edge, the thickness of the light emitting element cover insulation layers 400/501/510/511 may have a thickness of about 4.5 µm, and the horizontal distance BMPB from the boundary of the opening OP of the pixel defining layer 380 to the boundary of the edge second opening OPBMb may be about 4.0 µm.

A third area Area 3 is an area about 400 µm to about 600 µm from the edge, and the thickness of the light emitting element cover insulation layers 400/501/510/511 may have a thickness of about 5.47 µm, and the horizontal distance BMPB from the boundary of the opening OP of the pixel defining layer 380 to the boundary of the edge second opening OPBMb may be about 4.52 µm.

The fourth area Area 4 is an area from about 600 µm to about 1000 µm from the edge, and the thickness of the light emitting element cover insulation layers 400/501/510/511 may have a thickness of about 6.49 µm, and the horizontal distance BMPB from the boundary of the opening OP of the pixel defining layer 380 to the boundary of the edge second opening OPBMb may be about 4.99 µm.

The first area Area 1 to the fourth area Area 4 may be the edge area, and the fifth area Area 5 may be the central area.

The fifth area Area 5, which is the central area, is an area about 1000 µm or more from the edge, and corresponds to the majority of the display area DA. In the fifth area Area 5, which is the central area, the thickness of the light emitting element cover insulation layers 400/501/510/511 may have a thickness of about 7.18 µm, and the horizontal distance BMPB from the boundary of the opening OP of the pixel defining layer 380 to the boundary of the edge second opening OPBMb may be about 5.30 µm.

Referring to FIG. 17, a thickness difference of the light emitting element cover insulation layers 400/501/510/511 occurring in the edge area having a width of about 1 mm is about 4.25 µm, and depending on the embodiment, another thickness difference may occur.

The horizontal distance BMPB described in FIG. 17 is a value according to an embodiment, and the horizontal distance BMPB from the boundary of the opening OP of the pixel defining layer 380 of the edge area to the boundary of the edge second opening OPBMb may have a value from about 2.85 µm to about 7.18 µm. That is, the edge second opening OPBMb may be formed by about 0 µm to about 4.25 µm (7.18-2.93=4.25) less than the central second opening OPBMa, and the horizontal distance BMPB of the edge second opening OPBMb may be the horizontal distance of formed by about 0 µm to about 4.25 µm less than the central second opening OPBMa.

Depending on the embodiment, the edge area may be formed in a width greater than about 1 mm, and may be formed in a width of about 3 mm or less.

Referring to FIG. 16 and FIG. 17, unlike other areas (the first area to the third area) of the edge area, the fourth area Area 4 may have a width of about 400 µm. The fourth area Area 4 has a wide width because the degree to which the height of the light emitting element cover insulation layer is decreased increases toward the edge so that the height change of the light emitting element cover insulation layer is relatively small in the fourth area Area 4.

According to the embodiment of FIG. 16 and FIG. 17 described above, since the edge area is divided into the plurality of areas, and the size of the second opening is formed smaller than the central area, the bright band phenomenon may not appear in the edge area.

In the embodiment of FIG. 16 and FIG. 17, the edge area is divided into four areas, but it may have one area or more and three areas or less, or may be divided into five or more areas. In addition, it may have a structure in which the size of the second opening gradually increases from the edge to the central area.

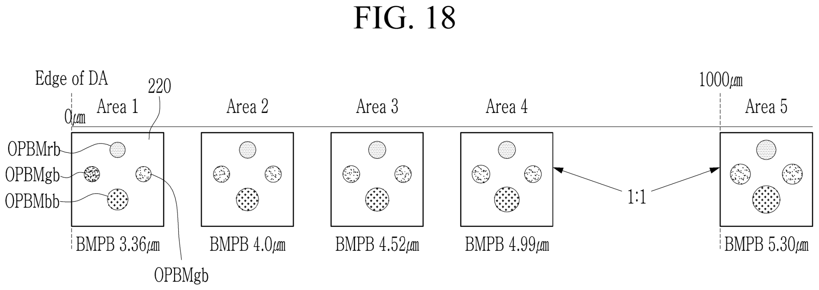

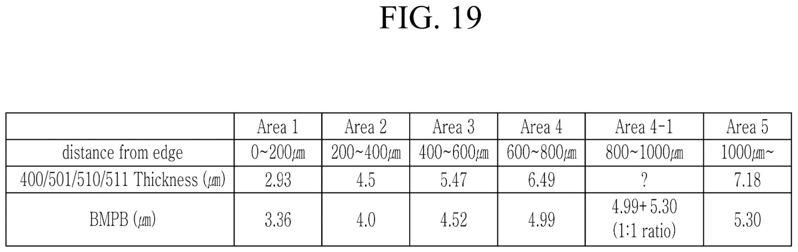

Depending on the embodiment, the fourth area Area 4 may also be divided into two areas having widths of about 200 µm, and a method of forming an additional area between the two areas simply will be described with reference to FIG. 18 and FIG. 19.

FIG. 18 is a drawing showing a change of the second opening in a display panel according to an embodiment, and FIG. 19 is a table summarizing sizes depending on positions of the second opening according to the embodiment of FIG. 18.

FIG. 18 may correspond to FIG. 16, FIG. 19 may correspond to FIG. 17, and an additional area Area 4-1 is further included between the fourth area Area 4 and the fifth area Area 5. That is, all of the first area Area 1 to the fifth area Area 5 have the same characteristics.

When it is necessary to form the additional area Area 4-1 between the fourth area Area 4 and the fifth area Area 5 and the thickness of the light emitting element cover insulation layers 400/501/510/511 in the additional area Area 4-1 has not been confirmed (indicated by a question mark "?" in FIG. 19), the additional area Area 4-1 may be formed as in FIG. 18 and FIG. 19.

In FIG. 18 and FIG. 19, two areas located on both sides of the additional area Area 4-1-that is, the fourth area Area 4 and the fifth area Area 5-are alternately formed in a 1:1 ratio to form the additional area Area 4-1. That is, in the additional area Area 4-1, pixels of which the horizontal distance BMPB from the boundary of the opening OP of the pixel defining layer 380 to the boundary of the edge second opening OPBMb are about 4.99 µm as in the fourth area Area 4 and pixels of which the horizontal distance BMPB from the boundary of the opening OP of the pixel defining layer 380 to the boundary of the edge second opening OPBMb is about 5.30 µm as in the fifth area Area 5, which is the central area, are alternately formed in a 1:1 ratio. According to such a method, it is not necessary to check the thickness of the light emitting element cover insulation layer, and it is not necessary to determine the horizontal distance BMPB, and the additional area may be formed easily by using the horizontal distances BMPB of adjacent areas.

That is, the additional area Area 4-1 located between two adjacent areas Area 4 and Area 5, among the plurality of areas of the edge area, may include the edge second openings OPBMb located in each of the two areas Area 4 and Area 5, located on either side of the additional area Area 4-1. In addition, the additional area Area 4-1 may include the edge second opening OPBMb formed in each of the two areas Area 4 and Area 5, located on each side of the additional area Area 4-1 in a 1:1 ratio.

In the embodiment of FIG. 18 and FIG. 19, compared to the embodiment of FIG. 16 and FIG. 17, the additional area is further included in the edge area, and accordingly, the bright band phenomenon may not appear in the edge area.

Depending on the embodiment, unlike FIG. 18 and FIG. 19, the ratio of two adjacent areas may be formed at a ratio other than 1:1 (e.g., 1:n, where n is a positive value other than 1), so that more pixels of one area may be included.

When the edge second openings OPBMb of two areas are intermixed, depending on the embodiment, more edge second openings OPBMb of an area located closer to a corresponding position may be formed than edge second openings OPBMb of an area located further away. For example, when a plurality of additional areas are formed between the third area Area 3 and the fourth area Area 4 and the edge second openings OPBMb are determined in portions about 500 µm away from the edge and about 550 µm away from the edge, if the edge second opening OPBMb of the third area Area 3 and the edge second opening OPBMb of the fourth area Area 4 is formed in a 1:1 ratio in the portion of about 500 µm, the ratio of the edge second opening OPBMb of the third area Area 3 and the edge second opening OPBMb of the fourth area Area 4 may be set to 1:2 in the portion of about 550 µm, so that the ratio of the edge second opening OPBMb of the fourth area Area 4 that is located closer may be increased.

In addition, depending on the embodiment, a plurality of areas may be formed in the additional area at a ratio that is gradually changed according to the distance from the edge within the additional area.

Depending on the embodiment, the one additional area may include not only the second edge second opening of two adjacent areas, but also the edge second openings of other areas that are distant, or of a different size than the edge second opening of other areas of different sizes.

In the above, an embodiment in which the second openings of the edge area and the central area are in a circular planar shape was discussed. However, a planar shape of the second opening of the edge area and/or the central area may be in another shape such as an ellipse and a polygon, and may be formed in various planar shapes.

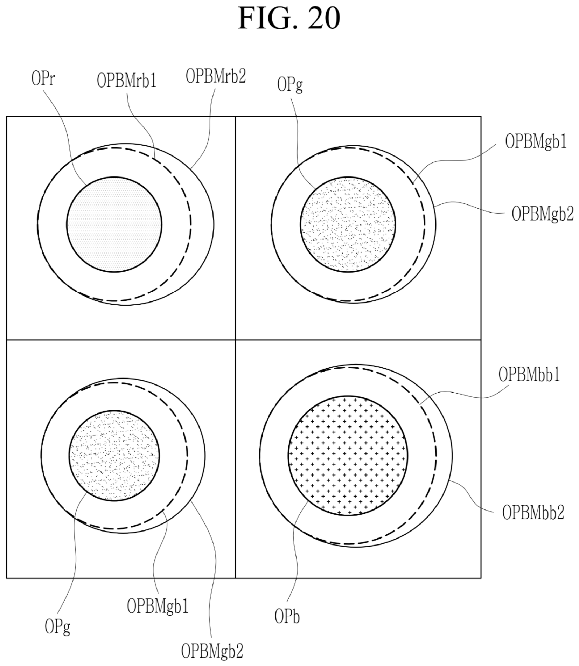

An embodiment of the second opening of the edge area in a planar shape extending from a circular shape toward an inner side of the display area will be described with reference to FIG. 20 below.

FIG. 20 is a drawing showing the manner of change of a second opening in an edge area in a display panel according to an embodiment.

In FIG. 20, the second openings OPBMrb2, OPBMgb2, and OPBMbb2 formed by extending the circular second openings OPBMrb1, OPBMgb1, and OPBMbb1 (illustrated with a dotted line) formed in the edge area inward-that is, toward the central area of the display area-are illustrated. Depending on the embodiment, a circular shape of the second opening of the edge area is elongated in one direction, and the second opening of the edge area may have an elliptical planar shape.

The edge area illustrated in FIG. 20 is the edge area located to the left of the central area, and the second opening extends in a rightward direction. Depending on the position of the edge area, the extending direction may vary. That is, since the edge areas are located along four sides of the display area DA, the directions along which the edge second opening is elongated from the edge area located on each side may be the same, and there may be a total of four directions in which the edge second opening extends in the entire edge area. Thus, the edge second openings in the border region of the display device extend asymmetrically toward the center of the display area.

In the embodiment of FIG. 20, the circular second openings OPBMrb1, OPBMgb1, and OPBMbb1 illustrated as dotted lines may be the second openings smaller than the second openings of the central area, such as the edge areas of FIG. 8, and FIG. 16 to FIG. 19.

When the edge second openings OPBMrb2, OPBMgb2, and OPBMbb2 elongated in one direction in the edge area as in the embodiment of FIG. 20 are formed, the light emitting element cover insulation layer corresponding to the extending portion among the edge second openings OPBMrb2, OPBMgb2, and OPBMbb2 is relatively thick, so the brightness of pixels is not affected and the second openings OPBMrb2, OPBMgb2, and OPBMbb2 may be extended in a corresponding direction.

The degree to which the second openings OPBMrb2, OPBMgb2, and OPBMbb2 extend in one direction may vary depending on the thickness of the corresponding light emitting element cover insulation layer, and when the thickness of the correspond light emitting element cover insulation layer is relatively large, the extending degree may be formed to be large.

Depending on the embodiment, the embodiment of FIG. 20 may be applied in all areas of the edge areas of FIG. 16 to FIG. 19, or in at least one area among the plurality of edge areas. Depending on the embodiment, the embodiment of FIG. 20 may be applied only to a portion of the edge second openings located in the entire or partial edge area.

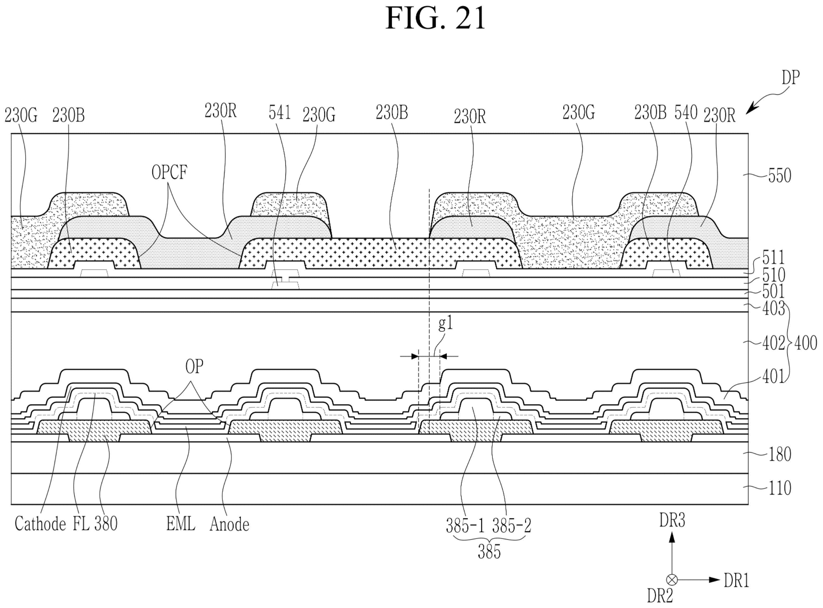

In the above, the embodiment in which the second opening is formed in the light blocking layer 220 was discussed. However, depending on the embodiment, a light shielding area of the color filter in which at least two color filters 230R, 230G, and 230B overlap may be formed instead of the light blocking layer 220. Hereinafter, an embodiment that does not include the light blocking layer but includes the light shielding area of the color filter in which the at least two color filters 230R, 230G, and 230B overlap will be described with reference to FIG. 21 to FIG. 23.

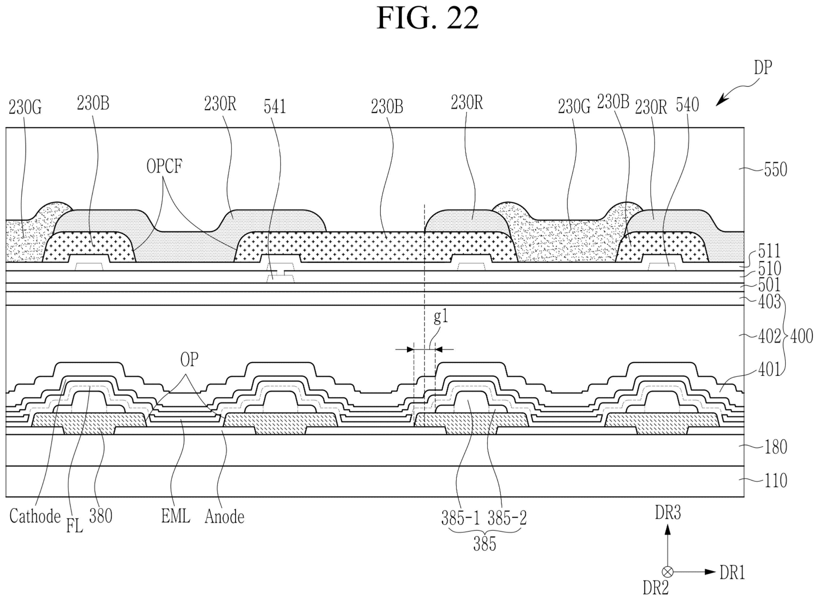

First, the deformation structure of FIG. 6 will be described with reference to FIG. 21 and FIG. 22.

FIG. 21 and FIG. 22 are schematic cross-sectional views of a display panel DP according to an embodiment.

Hereinafter, with reference to FIG. 21, a structure of the light emitting display panel DP according to an embodiment will be first described, and a description that is the same as in FIG. 6 will not be included herein.

The light emitting display panel DP according to the embodiment of FIG. 21 may display an image by forming light emitting diodes on the substrate 110, may sense touches by including the plurality of sensing electrodes 540 and 541, and may provide color characteristics of the color filters 230R, 230G, and 230B to the light emitted from the light emitting diode by including the color filters 230R, 230G, and 230B. The light blocking layer configured to block visible rays by being formed in black may not be formed, and visible rays may be blocked by overlapping at least two color filters instead of the light blocking layer.

An area configured to block visible rays by overlapping at least two color filters may be referred to as the light shielding area, and in the embodiment of FIG. 21, the blue color filter 230B, the red color filter 230R, and the green color filter 230G are sequentially stacked. The sequence in which the color filters are stacked may be variously modified depending on the embodiment.

In addition, a polarizing plate is not formed on the front surface of the light emitting display panel DP according to the embodiment of FIG. 21, and instead, the pixel defining layer 380 is formed of a black organic material while the light shielding area in which at least two color filters overlap is formed in an upper portion of the pixel defining layer 380, so that even if external light enters the inside, it may be reflected from the anode Anode or the like and may not be transferred to the user.

In more detail, the color filters 230R, 230G, and 230B may be located on the third sensing insulation layer 511. The color filters 230R, 230G, and 230B may include the red color filter 230R transmitting red light, the green color filter 230G transmitting green light, and the blue color filter 230B transmitting blue light. Each of the color filters 230R, 230G, and 230B may be located to overlap with the anode Anode of the light emitting diode in a plan view. As the light emitted from the emission layer EML may pass through a color filter to be changed to a corresponding color and then be emitted, the light emitted from the emission layer EML may all have the same color. However, the emission layer EML may display light of different colors, and may allow the light to pass through a color filter of the same color, to strengthen the displayed color.

Depending on the embodiment, the color filters 230R, 230G, and 230B may be replaced with color conversion layers, or may further include color conversion layers. The color conversion layer may include quantum dots.

In the embodiment of FIG. 21, the light blocking layer configured to block visible rays by being formed in black may not be formed, and the light blocking layer may be replaced by forming the light shielding area formed by overlapping at least two color filters, instead of the light blocking layer. In the embodiment of FIG. 21, in the light shielding area, the blue color filter 230B, the red color filter 230R, and the green color filter 230G are sequentially stacked. The sequence in which the color filters are stacked may be variously modified depending on the embodiment.

The light shielding area in which at least two color filters overlap may be located to overlap with the sensing electrodes 540 and 541 in a plan view, and may be located not to overlap with the anode Anode in a plan view. This is to prevent the anode Anode and the emission layer EML, which can display images, from being blocked by the light shielding area and the sensing electrodes 540 and 541.

Referring to FIG. 21, the light shielding area of the color filter in which three color filters overlap may be located only in an area overlapping with the pixel defining layer 380 in a plan view, and one side of the light shielding area of the color filter is located inward from the corresponding side of the pixel defining layer 380.

Only one color filter may be located in the area excluding the light shielding area of the color filter, and light of the color of the corresponding color filter is transmitted, so that the light transmitting area of the color filter may be configured. Hereinafter, the light transmitting area of the color filter in which only one color filter is located may also be referred to as the second opening OPCF of the light shielding area, since light can pass through it. The second opening OPCF of the light shielding area may be the opening located in the light shielding area in which at least two color filters overlap, and may correspond to an area where only one color filter is located. In an embodiment, the second opening OPCF of the light shielding area of the color filter may correspond to the second opening OPBM of the light blocking layer 220 described above.

An area of the second opening OPCF of the light shielding area may be formed to be larger than the opening OP of the pixel defining layer 380, and in a plan view, the opening OP of the pixel defining layer 380 may be located within the second opening OPCF of the light shielding area.

In addition, one side of the spacer 385 is also located inward from the corresponding side of the pixel defining layer 380 by a preset interval g1, and the spacer 385 is located inward from one side of the light shielding area. As a result, when viewed from the front surface of the display panel DP, the spacer 385 may be obscured by the light shielding area.

When external light is incident, it may pass through the second opening OPCF of the light shielding area of the color filter, and then may be reflected from the side wall of the opening OP of the pixel defining layer 380. The side wall of the opening OP of the pixel defining layer 380 may form a curved surface, so that color separation occurs depending on the reflected position, and thereby the color of the reflection light may appear in a rainbow of colors. Since such color-separated reflection light may be easily visible to the user's eye and may degrade the display quality, the second opening OPBM of the light blocking layer 220 may be replaced with the second opening OPCF of the light shielding area of the color filter in embodiments such as FIG. 7. That is, at least one of the second opening OPCF of the light shielding area of the color filter and the opening OP of the pixel defining layer 380 may be formed in an elliptical shape, and the direction of the elliptical shape or the eccentricity of the elliptical shape may be varied so that color separation may be reduced or the reflection white light may be visible. Depending on the embodiment, it may be formed to have a shape equivalent to an elliptical shape although not exactly an elliptical shape, and the direction and eccentricity may be varied is various manners. In addition, various modifications with respect to the second opening OPBM of the light blocking layer 220 described above and the opening OP of the pixel defining layer 380 corresponding thereto may be applied to the second opening OPCF of the light shielding area of the color filter and the opening OP of the pixel defining layer 380.

The planarization layer 550 covering the color filters 230R, 230G, and 230B may be located on the color filters 230R, 230G, and 230B. The planarization layer 550 may be employed to planarize the upper surface of the light emitting display panel, and may be a transparent organic insulator including one or more materials selected from a group consisting of polyimide, polyamide, an acryl resin, benzocyclobutene, and a phenol resin.

Depending on the embodiment, in order to improve the frontal visibility and light emission efficiency of the display panel, a low-refractive layer and an additional planarization layer may be further located on the planarization layer 550. By the low-refractive layer and the additional planarization layer having high-refractive characteristics, light may be emitted while being refracted to the front surface. In this case, depending on the embodiment, since the planarization layer 550 is omitted, a low-refractive layer and an additional planarization layer may be located on the color filter.

In the present embodiment, a polarizing plate is not included in the upper portion of the planarization layer 550. That is, the polarizing plate may serve to prevent the display quality from being degraded when external light is incident and reflected from the anode Anode or the side wall of the opening OP of the pixel defining layer 380 and the user recognizes it. However, the polarizing plate not only reduces the reflection of the external light but also reduces light emitted from the emission layer EML, so that more electrical power needs to be consumed in order to display a preset brightness. In order to reduce power consumption, the light emitting display device of the present embodiment may not include a polarizing plate.

In addition, the present embodiment includes the structure in which the degree of reflection from the anode Anode is reduced by covering the side surface of the anode Anode by the pixel defining layer 380, and the degree of incident light is reduced by forming the light shielding area in which at least two color filters overlap, so that the degradation of display quality due to reflection is prevented. Therefore, the polarizing plate may not be separately formed on the front surface of the light emitting display panel DP.

In FIG. 21, the light shielding area with at least two color filters overlapping is illustrated in an embodiment where three color filters are overlapped. However, depending on the embodiment, the light shielding area of the color filter may be formed by overlapping two color filters, which is illustrated in FIG. 22.

FIG. 22 is a drawing corresponding to FIG. 6 and FIG. 21, and only differs from FIG. 21 in the color filters 230R, 230G, and 230B, so that the lower structure of the third sensing insulation layer 511 is the same as in FIG. 21. Hereinafter, the upper structure of the third sensing insulation layer 511, which differs from FIG. 21, will be discussed.

Referring to FIG. 22, the light blocking layer configured to block visible light may not be formed, and the blue color filter 230B and the red color filter 230R are sequentially located to overlap with each other in order to block visible light. The sequence in which the color filters are stacked may be variously modified depending on the embodiment.

Specifically, the blue color filter 230B and the red color filter 230R overlap with each other in the light shielding area where the two color filters overlap, and there is also a part where the green color filter 230G overlaps in some of the light shielding areas of the color filter. However, the green color filter 230G is not formed entirely over the light shielding area of the color filter, and unlike the embodiment of FIG. 21, it may be an embodiment in which the light shielding area of the color filter is formed with only two color filters. The light shielding area in which two color filters overlap may be located only in an area overlapping with the pixel defining layer 380 in a plan view, and one side of the light shielding area of the color filter is located inward from the corresponding side of the pixel defining layer 380.

Only one color filter may be located in the area excluding the light shielding area of the color filter, and light of the color of the corresponding color filter is transmitted to form the light transmission area of the color filter or the second opening OPCF of the color filter. The area of the second opening OPCF of the color filter may be formed to be larger than the opening OP of the pixel defining layer 380, and in a plan view, the opening OP of the pixel defining layer 380 may be located within the second opening OPCF of the color filter of the light shielding area.

The light shielding area of the color filter may overlap with the spacer 385 and the plurality of sensing electrodes 540 and 541 in a plan view, in addition to the pixel defining layer 380. Specifically, in the light shielding area of the color filter, one side of the spacer 385 is also located inward from a corresponding side of the pixel defining layer 380 by a preset interval g1, and the spacer 385 is located inward from one side of the light shielding area of the color filter. In addition, the plurality of sensing electrodes 540 and 541 is covered with the light shielding area of the color filter in a plan view. As a result, when viewed from the front surface of the display panel DP, the spacer 385 and the plurality of sensing electrodes 540 and 541 may not be visible by being obscured by the light shielding area of the color filter.

Depending on the embodiment, the color filters 230R, 230G, and 230B may be replaced with color conversion layers, or may further include color conversion layers. The color conversion layers may include quantum dots.

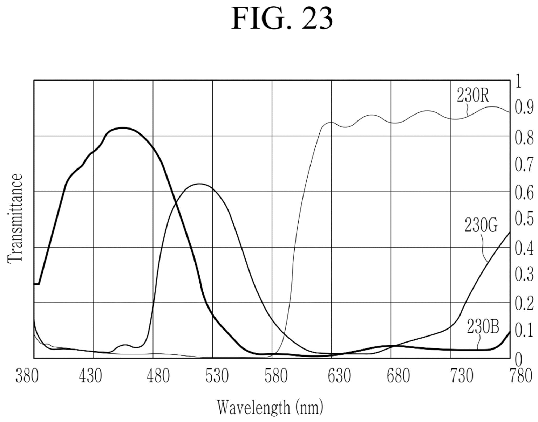

Hereinafter, whether the function of the light blocking layer may be replaced by stacking two color filters will be discussed with reference to FIG. 23.

FIG. 23 is a graph showing the transmittance of the color filter depending on its wavelength.

FIG. 23 is a graph showing transmittance versus wavelengths of the color filters 230R, 230G, and 230B, so light of wavelength range in the portion indicated to be high may be transmitted. Referring to FIG. 23, it may be confirmed that another portion excluding the wavelength band transmitted through the color filters 230R, 230G, and 230B has transmittance of less than 10%, and when three or two color filters are overlapped, the transmitted wavelength band hardly exists. Therefore, overlapping at least two may replace the function of the light blocking layer, confirming that the three color filters may be overlapped as in FIG. 21, or the two color filters may be overlapped as in FIG. 22.

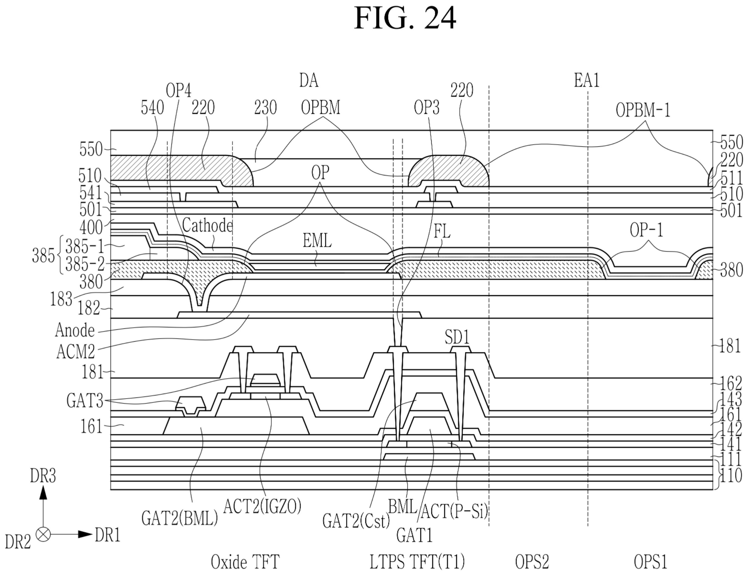

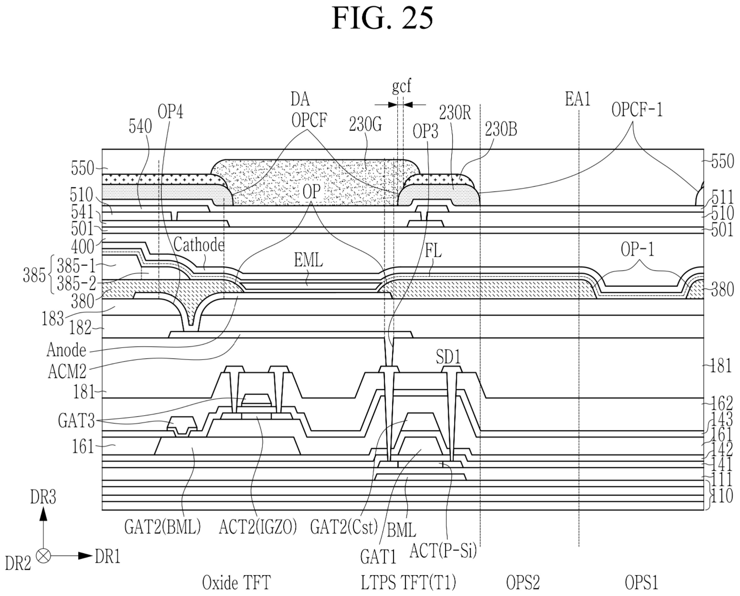

Hereinafter, the stacking structure of the display area DA and the first component area EA1 will be described in more detail, with reference to FIG. 24 and FIG. 25.

FIG. 24 and FIG. 25 are cross-sectional views of a light emitting display device according to an embodiment.

FIG. 24 shows an embodiment including the light blocking layer 220, and FIG. 25 shows an embodiment in which the blue color filter 230B and the red color filter 230R are overlapped instead of the light blocking layer 220 to form the light shielding region of the color filter.

First, the embodiment of FIG. 24 will be discussed in detail.

The light emitting display device may be largely divided into a lower panel layer and an upper panel layer, and the lower panel layer may be a portion in which the light emitting diode and the pixel circuit section constituting a pixel are located, and may also include the encapsulation layer 400 covering the same. Here, the pixel circuit section may include a second organic layer 182 and a third organic layer 183 and mean a configuration below them, and the light emitting diode may be above the third organic layer 183, and may mean a configuration located below the encapsulation layer 400. The structure located in an upper portion of the encapsulation layer 400 may correspond to the upper panel layer.

Referring to FIG. 24, a metal layer BML may be located on the substrate 110.

The substrate 110 may include a material that does not bend due to rigid characteristics such as glass, or may include a flexible material that can be bent such as plastic or polyimide. As shown in FIG. 24, the flexible substrate may have a structure in which a dual-layer structure of polyimide and a barrier layer formed of an inorganic insulating material thereon is formed.

The metal layer BML may be formed at a position overlapping with a channel of a driving transistor T1 in a subsequent first semiconductor layer in a plan view, and may be referred to as a lower shielding layer. The metal layer BML may include a metal such as copper (Cu), molybdenum (Mo), aluminum (Al), titanium (Ti), or the like, or a metal alloy thereof.

On the substrate 110 and the metal layer BML, a buffer layer 111 covering it may be located. The buffer layer 111 may serve to block penetration of impure elements into a first semiconductor layer ACT(P-Si), and may be an inorganic insulation layer including silicon oxide (SiOx) or silicon nitride (SiNx), silicon oxynitride (SiONx), or the like.

The first semiconductor layer ACT(P-Si) formed of a silicon semiconductor (e.g., polycrystalline semiconductor (P-Si)) may be located on the buffer layer 111. The first semiconductor layer ACT(P-Si) may include a channel of a polycrystalline transistor LTPS TFT including the driving transistor T1 and the first area and the second area located on both sides thereof. Here, the polycrystalline transistor LTPS TFT may include not only the driving transistor T1 but also various switching transistors or compensation transistors. In addition, by plasma treatment or doping on both sides of the channel of the first semiconductor layer ACT(P-Si), an area having conductive layer characteristics may be formed, to serve as a first electrode and a second electrode of the transistor.

A first gate insulation layer 141 may be located on the first semiconductor layer ACT(P-Si). The first gate insulation layer 141 may be an inorganic insulation layer including silicon oxide (SiOx), silicon nitride (SiNx), silicon oxynitride (SiONx), or the like.

A first gate conductive layer GAT1 including a gate electrode of the polycrystalline transistor LTPS TFT may be located on the first gate insulation layer 141. In addition to the gate electrode of the polycrystalline transistor LTPS TFT, a first scan line or a light emission control line may be formed in the first gate conductive layer GAT1. The first gate conductive layer may include a metal such as copper (Cu), molybdenum (Mo), aluminum (Al), titanium (Ti), or the like, or a metal alloy thereof, and may be formed in a single layer or in multiple layers.

By performing the plasma treatment or doping process after forming the first gate conductive layer GAT1, the exposed area of the first semiconductor layer may become conductive. That is, the first semiconductor layer ACT(P-Si) covered by the first gate conductive layer GAT1 may not become conductive, and the portion of the first semiconductor layer ACT(P-Si) that is not covered by the first gate conductive layer GAT1 may have the same characteristics as the conductive layer.

A second gate insulation layer 142 may be located on the first gate conductive layer GAT1 and the first gate insulation layer 141. The second gate insulation layer 142 may be an inorganic insulation layer including silicon oxide (SiOx), silicon nitride (SiNx), silicon oxynitride (SiONx), or the like.

A second gate conductive layer including one electrode GAT2(Cst) of a sustain capacitor Cst and a lower shielding layer GAT2(BML) of an oxide transistor Oxide TFT may be located on the second gate insulation layer 142. The lower shielding layer GAT2(BML) of the oxide transistor Oxide TFT may be located at a lower portion of a channel of the oxide transistor Oxide TFT and can serve to shield the channel from light, electromagnetic interference, or the like provided to the channel from a lower side. The electrode GAT2(Cst) of the sustain capacitor Cst may overlap with a gate electrode GAT1 of the driving transistor T1 to form the sustain capacitor Cst. Depending on the embodiment, the second gate conductive layer may further include a scan line, a control line, or a voltage line. The second gate conductive layer may include a metal such as copper (Cu), molybdenum (Mo), aluminum (Al), titanium (Ti), or the like, or a metal alloy thereof, and may be formed in a single layer or in multiple layers.

A first interlayer insulation layer 161 may be located on the second gate conductive layer. The first interlayer insulation layer 161 may include an inorganic insulation layer including silicon oxide (SiOx), silicon nitride (SiNx), silicon oxynitride (SiONx), or the like, and depending on the embodiment, the inorganic insulating material may be formed to be thick.

An oxide semiconductor layer ACT2(IGZO) including the channel, the first area, and the second area of the oxide transistor Oxide TFT may be located on the first interlayer insulation layer 161.

A third gate insulation layer 143 may be located on the oxide semiconductor layer ACT2(IGZO). The third gate insulation layer 143 may be located on the oxide semiconductor layer ACT2(IGZO) and the front surface on the first interlayer insulation layer 161. The third gate insulation layer 143 may include an inorganic insulation layer including silicon oxide (SiOx), silicon nitride (SiNx), silicon oxynitride (SiONx), or the like.

A third gate conductive layer GAT3 including a gate electrode of the oxide transistor Oxide TFT may be located on the third gate insulation layer 143. The gate electrode of the oxide transistor Oxide TFT may overlap with the channel. The third gate conductive layer GAT3 may further include a scan line or a control line, and may additionally include a connecting electrode connected to the lower shielding layer GAT2(BML) of the oxide transistor Oxide TFT. The third gate conductive layer GAT3 may include a metal such as copper (Cu), molybdenum (Mo), aluminum (Al), titanium (Ti), or the like, or a metal alloy thereof, and may be formed in a single layer or in multiple layers.

A second interlayer insulation layer 162 may be located on the third gate conductive layer GAT3. The second interlayer insulation layer 162 may have a structure of a single layer or multiple layers. The second interlayer insulation layer 162 may include an inorganic insulating material such as silicon nitride (SiNx), silicon oxide (SiOx), and silicon oxynitride (SiOxNy), and depending on the embodiment, may include an organic material.

A first data conductive layer SD1 including the connecting electrode that can be connected to the first area and the second area of each of the polycrystalline transistor LTPS TFT and the oxide transistor Oxide TFT may be located on the second interlayer insulation layer 162. The first data conductive layer SD1 may include a metal such as aluminum (Al), copper (Cu), molybdenum (Mo), titanium (Ti), or the like, or a metal alloy thereof, and may be formed in a single layer or in multiple layers.

A first organic layer 181 may be located on the first data conductive layer SD1. The first organic layer 181 may be an organic insulator including an organic material, and the organic material may include one or more materials selected from the group consisting of polyimide, polyamide, an acryl resin, benzocyclobutene, and a phenol resin.

A second data conductive layer including an anode connecting electrode ACM2 may be located on the first organic layer 181. The second data conductive layer may include a data line or a driving voltage line. The second data conductive layer may include a metal such as aluminum (Al), copper (Cu), molybdenum (Mo), titanium (Ti), or the like, or a metal alloy thereof, and may be formed in a single layer or in multiple layers.

The second organic layer 182 and the third organic layer 183 may be located on the second data conductive layer, and the opening OP4 for an anode connection may be formed in the second organic layer 182 and the third organic layer 183. The anode connecting electrode ACM2 may be electrically connected to the anode Anode through the opening OP4 for the anode connection. The second organic layer 182 and the third organic layer 183 may be an organic insulator, and may include one or more materials selected from the group consisting of polyimide, polyamide, an acryl resin, benzocyclobutene, and a phenol resin. Depending on the embodiment, the third organic layer 183 may be omitted.

The pixel defining layer 380 that covers at least a portion of the anode Anode while having the opening OP exposing the anode Anode may be located on the anode Anode. The pixel defining layer 380 may be a black pixel defining layer that is formed of a black organic material to prevent the light applied from the outside from being reflected to the outside, and depending on the embodiment, may be formed of a transparent organic material. Therefore, depending on the embodiment, the pixel defining layer 380 may include a negative-type black organic material, and may include a black pigment.

The spacer 385 may be located on the pixel defining layer 380. The spacer 385 includes a first portion 385-1 located in a tall and narrow area and a second portion 385-2 located in a low and wide area. Unlike the pixel defining layer 380, the spacer 385 may be formed of a transparent organic insulating material. Depending on the embodiment, the spacer 385 may be formed of a positive-type transparent organic material.

The functional layer FL and the cathode Cathode may be sequentially formed on the anode Anode, the spacer 385, and the pixel defining layer 380, and in the display area DA and the first component area EA1, the functional layer FL and the cathode Cathode may be located in an entire area. The emission layer EML may be located between the functional layers FL, and the emission layer EML may only be located within the opening OP of the pixel defining layer 380. Hereinafter, the functional layer FL and the emission layer EML may be collectively referred to as an intermediate layer. The functional layer FL may include at least one layer among auxiliary layers such as the electron injection layer (EIL), the electron transport layer, and the hole transport layer, and the hole injection layer (HIL), the hole injection layer (HIL) and the hole transport layer may be located in the lower portion of the emission layer EML, and the electron transport layer and the electron injection layer (EIL) may be located in the upper portion of the emission layer EML.

The encapsulation layer 400 may be located on the cathode Cathode. The encapsulation layer 400 may include at least one inorganic layer and at least one organic layer, and depending on the embodiment, may have a triple-layer structure including a first inorganic encapsulation layer, an organic encapsulation layer, and a second inorganic encapsulation layer. The encapsulation layer 400 may protect the emission layer EML from moisture, oxygen, or the like that may be introduced from the outside. Depending on the embodiment, the encapsulation layer 400 may include a structure in which an inorganic layer and an organic layer are sequentially further stacked.

On the encapsulation layer 400, the sensing insulation layers 501, 510, and 511 and the plurality of sensing electrodes 540 and 541 may be located to sense touches. In the embodiment of FIG. 24, touch may be sensed in a capacitive type by using the two sensing electrodes 540 and 541.

Specifically, the first sensing insulation layer 501 may be formed on the encapsulation layer 400, and the plurality of sensing electrodes 540 and 541 may be formed thereon. The plurality of sensing electrodes 540 and 541 may be insulated by interposing the second sensing insulation layer 510, and a part may be electrically connected through the opening located in the second sensing insulation layer 510. Here, the sensing electrodes 540 and 541 may include a metal such as aluminum (Al), copper (Cu), silver (Ag), gold (Au), molybdenum (Mo), titanium (Ti), tantalum (Ta), or the like, or a metal alloy thereof, and may be formed in a single layer or in multiple layers. The third sensing insulation layer 511 is formed on the sensing electrode 540.

The light blocking layer 220 and the color filters 230R, 230G, and 230B, illustrated generally as the color filter 230, may be located on the third sensing insulation layer 511.

The light blocking layer 220 may be located to overlap with the sensing electrodes 540 and 541 in a plan view. The light blocking layer 220 has the second opening OPBM, and the second opening OPBM of the light blocking layer 220 may overlap with the opening OP of the pixel defining layer 380 in a plan view. In addition, the second opening OPBM of the light blocking layer 220 may be formed to be wider than the opening OP of the pixel defining layer 380. As a result, the anode Anode overlapping with the opening OP of the pixel defining layer 380 (i.e., exposed by the opening OP of the pixel defining layer 380) may have a structure that is not covered by the light blocking layer 220 in a plan view. This is to prevent the anode Anode and the emission layer EML, which can display images, from being covered by the light blocking layer 220 and the sensing electrodes 540 and 541. In addition, the light blocking layer 220 has a structure that overlaps with the opening OP4 for the anode connection in a plan view but does not overlap with an opening OP3 of the first organic layer 181 in a plan view.

The color filters 230R, 230G, and 230B may be located on the sensing insulation layers 501, 510, and 511 and the light blocking layer 220. Depending on the embodiment, the color filters 230R, 230G, and 230B may be replaced with color conversion layers, or may further include color conversion layers. The color conversion layer may include quantum dots.

The planarization layer 550 covering the color filters 230R, 230G, and 230B may be located on the color filters 230R, 230G, and 230B, and depending on the embodiment, in order to improve the frontal visibility and light emission efficiency of the display device, a low-refractive layer and an additional planarization layer may be further located on the planarization layer 550. By the low-refractive layer and the additional planarization layer having a high-refractive characteristic, light may be emitted while being refracted to the front surface. In this case, depending on the embodiment, since the planarization layer 550 is omitted, a low-refractive layer and an additional planarization layer may be located on the color filter 230.

In the present embodiment, a polarizing plate is not included in the upper portion of the planarization layer 550. That is, the polarizing plate may serve to prevent the display quality from being degraded when external light is incident and reflected from the anode Anode and the user recognizes it. However, the present embodiment already includes the structure in which the degree of reflection from the anode Anode is reduced by covering the side surface of the anode Anode by the pixel defining layer 380, and the degree of incident light is reduced by forming the light blocking layer 220, so that the degradation of display quality due to reflection is prevented. Therefore, the polarizing plate may not be separately formed on the front surface of the display panel DP.

In FIG. 24, in addition to the stacking structure of the display area DA, a cross-section structure of the first component area EA1 that is formed so that light may pass through a portion of the display area DA is illustrated.

FIG. 24 illustrates that the first component area EA1 is divided into a first photosensor area OPS1 (also referred to as a transmissive photosensor area) and a second photosensor area OPS2 (also referred to as a non-transmissive photosensor area). Here, the first photosensor area OPS1 may be an area formed to allow light to pass through with additional openings OP-1 and OPBM-1 located so as not to overlap in a plan view with the pixel defining layer 380 and the light blocking layer 220. In contrast, the second photosensor area OPS2 may be an area formed to block transmission of light by overlapping with the pixel defining layer 380 in a plan view. According to an embodiment, the second photosensor area OPS2 may overlap not only with the pixel defining layer 380 but also additionally with the light blocking layer 220 in a plan view. The first photosensor area OPS1 and the second photosensor area OPS2 of the first component area EA1 may not include a layer configured to block light, such as the metal layer and the semiconductor layer. For reference, the first optical element ES1 (see FIG. 2) may be located on the back surface of the first component area EA1, and may sense the front surface of the light emitting display device through the first photosensor area OPS1 located in the first component area EA1.

Specifically, the layered structure of the first component area EA1 is as follows.

The buffer layer 111, which is an inorganic insulation layer, may be located on the substrate 110, and the first gate insulation layer 141 and the second gate insulation layer 142, which are an inorganic insulation layers, are sequentially stacked thereon. In addition, the first interlayer insulation layer 161, the third gate insulation layer 143, and the second interlayer insulation layer 162, which are inorganic insulation layers, are sequentially stacked on the second gate insulation layer 142.

The first organic layer 181, the second organic layer 182, and the third organic layer 183, which are organic insulators, are sequentially stacked on the second interlayer insulation layer 162.

The functional layer FL may be located on the third organic layer 183, and the cathode Cathode may be located thereon.

The encapsulation layer 400 may be located on the cathode Cathode, and the sensing insulation layers 501, 510, and 511 may be sequentially located thereon. The encapsulation layer 400 may have a triple-layer structure sequentially including the inorganic encapsulation layer, the organic encapsulation layer, and the inorganic encapsulation layer. In addition, the sensing insulation layers 501, 510, and 511 may all be inorganic insulation layers.

The planarization layer 550 may be located on the sensing insulation layers 501, 510, and 511.

The metal layer, the first semiconductor layer, the first gate conductive layer, the second gate conductive layer, the oxide semiconductor layer, the third gate conductive layer, the first data conductive layer, the second data conductive layer, and the anode Anode are not located in the first component area EA1 described above. In addition, the emission layer EML, and the sensing electrodes 540 and 541 are not formed.

In addition, in the first photosensor area OPS1 in the first component area EA1, each of the additional openings OP-1 and OPBM-1 are formed in the pixel defining layer 380 and the light blocking layer 220, respectively, so that the pixel defining layer 380 and the light blocking layer 220 may not be formed. As a result, light may pass through the first photosensor area OPS1. In contrast, the second photosensor area OPS2 in the first component area EA1 may have a structure that does not have the additional openings OP-1 of the pixel defining layer 380, and thus does not transmit light overlapping with the pixel defining layer 380.

In the above, an embodiment in which a total of three organic layers are formed and the opening for connecting anodes is formed in the second organic layer and the third organic layer has been described. However, at least two organic layers may be formed, and in this case, the opening for connecting anodes may be located in an upper organic layer located away from the substrate, and the lower organic layer opening may be located in the lower organic layer.

Hereinafter, an embodiment of forming the light shielding area of the color filter by overlapping the blue color filter 230B and the red color filter 230R instead of the light blocking layer 220 will be described with reference to FIG. 25.

In FIG. 25, a structure of the third sensing insulation layer 511 and the structure below it is the same as that of FIG. 24, so only the upper structure of the third sensing insulation layer 511, which differs from FIG. 24, is discussed hereinbelow.

The color filters 230R, 230G, and 230B may be located on the third sensing insulation layer 511. In the embodiment of FIG. 25, the light blocking layer may not be included, the function of the light blocking layer is performed by the overlapping color filters 230R and 230B, and the overlapping color filters 230R and 230B may be located to overlap with the sensing electrodes 540 and 541 in a plan view. The overlapping color filters 230R and 230B have the second opening OPCF, and the second opening OPCF of the overlapping color filters 230R and 230B may overlap with the opening OP of the pixel defining layer 380 in a plan view. In addition, the second opening OPCF of the overlapping color filters 230R and 230B may be formed to be wider than the opening OP of the pixel defining layer 380. As a result, the anode Anode overlapping with the opening OP of the pixel defining layer 380 (i.e., exposed by the opening OP of the pixel defining layer 380) may have a structure that is not covered by the overlapping color filters 230R and 230B in a plan view. This is to prevent the anode Anode and the emission layer EML, which can display images, from being covered by the overlapping color filters 230R and 230B and the sensing electrodes 540 and 541. In addition, the overlapping color filters 230R and 230B have a structure that overlaps with the opening for anode connection OP4 in a plan view.

Among the overlapping color filters 230R and 230B, a width of the blue color filter 230B located above a width of the red color filter 230R located below may be narrower than a color filter interval gcf, and depending on the embodiment, the color filter interval gcf may have a value of about 0 µm or more and about 2 µm or less. Depending on the embodiment, as shown in FIG. 21, when all three of the color filters overlap to form the light shielding area of the color filter having the same characteristics as the light blocking layer, the two color filters that are adjacent and overlapping with each other may have the color filter interval gcf, and the color filter interval gcf may have a value of about 0 µm or more and about 2 µm or less.

One color filter may be located within the second opening OPCF of the color filters 230R and 230B, and in FIG. 25, the green color filter 230G is located. Depending on the embodiment, the color filters 230R, 230G, and 230B may be replaced with color conversion layers, or may further include color conversion layers. The color conversion layer may include quantum dots.

The planarization layer 550 covering the color filters 230R, 230G, and 230B may be located on the color filters 230R, 230G, and 230B, and a low-refractive layer and an additional planarization layer may be further located on the planarization layer 550 in order to improve the frontal visibility and light emission efficiency of the display device. Depending on the embodiment, since the planarization layer 550 is omitted, a low-refractive layer and an additional planarization layer may be located on the color filter.

In the embodiment of FIG. 25, a polarizing plate is not included in the upper portion of the planarization layer 550. That is, the polarizing plate may serve to prevent the display quality from being degraded when external light is incident and reflected from the anode Anode and the user recognizes it. However, the present embodiment includes the structure in which the degree of reflection from the anode Anode is reduced by covering the side surface of the anode Anode by the pixel defining layer 380, and the degree of incident light is reduced by forming the overlapping color filters 230R and 230B, so that the degradation of display quality due to reflection is prevented. Therefore, the polarizing plate may not be separately formed on the front surface of the display panel DP.

The cross-section structure of the first component area EA1 according to the embodiment of FIG. 25 may be as follows.

The first component area EA1 may be divided into the first photosensor area OPS1 and the second photosensor area OPS2. Here, the first photosensor area OPS1 may be an area formed so that light can be transmitted since each of the additional openings OP-1 and OPCF-1 is located so as not to overlap with the light shielding area of the color filter formed as the pixel defining layer 380 and at least two color filters overlap with each other in a plan view. In contrast, the second photosensor area OPS2 may be an area formed to block transmission of light by forming to overlap with the pixel defining layer 380 in a plan view. According to an embodiment, the second photosensor area OPS2 may overlap not only with the pixel defining layer 380 but also additionally with the light shielding area of the color filter in a plan view. The first photosensor area OPS1 and the second photosensor area OPS2 of the first component area EA1 may not include a layer configured to block light, such as the metal layer and the semiconductor layer. For reference, the first optical element ES1 (see FIG. 2) may be located on the back surface of the first component area EA1, and the front surface of the light emitting display device may be sensed through the first photosensor area OPS1 located in the first component area EA1.

Specifically, the layered structure of the first component area EA1 is as follows.

The buffer layer 111, which is an inorganic insulation layer, may be located on the substrate 110, and the first gate insulation layer 141 and the second gate insulation layer 142, which are an inorganic insulation layers, are sequentially stacked thereon. In addition, the first interlayer insulation layer 161, the third gate insulation layer 143, and the second interlayer insulation layer 162, which are inorganic insulation layers, are sequentially stacked on the second gate insulation layer 142.

The first organic layer 181, the second organic layer 182, and the third organic layer 183, which are organic insulators, are sequentially stacked on the second interlayer insulation layer 162.

The functional layer FL may be located on the third organic layer 183, and the cathode Cathode may be located thereon.

The encapsulation layer 400 may be located on the cathode Cathode, and the sensing insulation layers 501, 510, and 511 may be sequentially located thereon. The encapsulation layer 400 may have a triple-layer structure sequentially including an inorganic encapsulation layer, an organic encapsulation layer, and an inorganic encapsulation layer. In addition, the sensing insulation layers 501, 510, and 511 may all be inorganic insulation layers.

The planarization layer 550 may be located on the sensing insulation layers 501, 510, and 511.

The metal layer, the first semiconductor layer, the first gate conductive layer, the second gate conductive layer, the oxide semiconductor layer, the third gate conductive layer, the first data conductive layer, the second data conductive layer, and the anode Anode are not located in the first component area EA1 described above. In addition, the emission layer EML, and the sensing electrodes 540 and 541 are not formed.

In addition, in the first photosensor area OPS1 in the first component area EA1, each of the additional openings OP-1 and OPCF-1 are formed in the pixel defining layer 380 and the light shielding area of the color filter, respectively, so that the pixel defining layer 380 and the color filter may not be formed. As a result, light may pass through the first photosensor area OPS1. In contrast, the second photosensor area OPS2 in the first component area EA1 may have a structure that does not have additional openings OP-1 of the pixel defining layer 380, thus preventing transmission of light by overlapping with the pixel defining layer 380.

In the above, an embodiment in which a total of three organic layers are formed and the opening for anode connection is formed in the second organic layer and the third organic layer has been described. However, at least two organic layers may be formed, and in this case, the opening for anode connection may be located in an upper organic layer located away from the substrate, and the lower organic layer opening may be located in the lower organic layer.

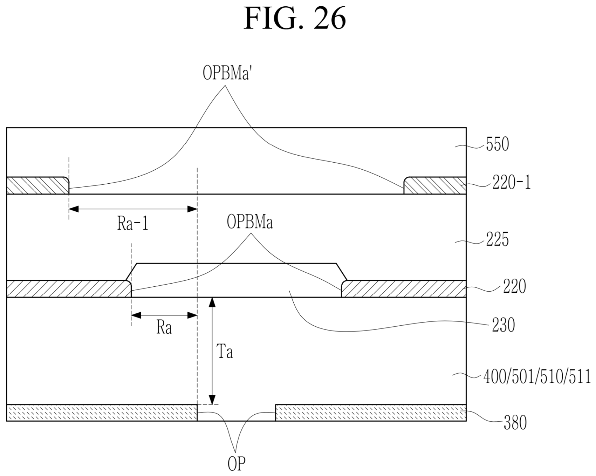

Meanwhile, according to an embodiment, the light blocking layer may include two or more layers, which will be described with reference to FIGS. 26 to 31.

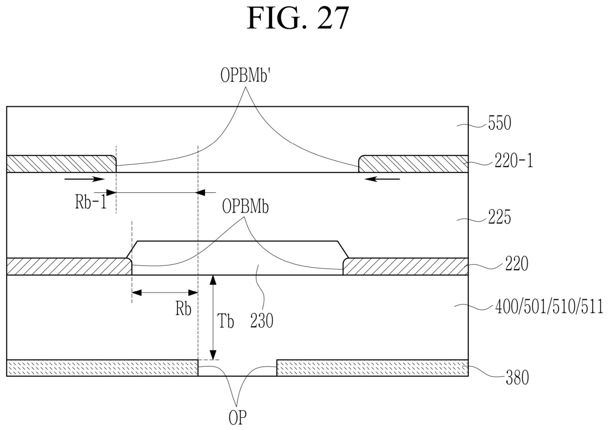

First, the features of the edge area will be described through a portion of the normal center pixel located in the central area and a portion of the edge pixel located in the edge area among the display area DA with reference to FIG. 26 and FIG. 27.

FIG. 26 is a cross-sectional view showing a second opening in a central area in a normal display area according to an embodiment, and FIG. 27 is a cross-sectional view showing a second opening in an edge area in a normal display area according to an embodiment.

FIG. 26 corresponds to FIG. 7, and FIG. 27 corresponds to FIG. 8, and the structure up to the pixel defining layer 380 and light emitting element cover insulation layers 400/501/510/511 is the same. Specifically, light emitting element cover insulation layers 400/501/510/511 includes the encapsulation layer 400, the first sensing insulation layer 501, the second sensing insulation layer 510, and the third sensing insulation layer 511.

The pixel defining layer 380 has an opening OP that overlaps in a plane corresponding to the emission layer (see EML of FIG. 6), and the light blocking layer 220 and the additional light blocking layer 220-1 (hereinafter also referred to as the second light blocking layer) respectively have a second opening OPBMa and OPBMb and a third opening OPBMa' and OPBMb' that overlap in a plane corresponding to the emission layer and/or the opening OP of the pixel defining layer 380.

In FIGS. 26 and 27, a color filter 230 formed in the second opening OPBMa and OPBMb of the light blocking layer 220 is also illustrated, and the light blocking layer 220 and the color filter 230 are covered by an intermediate planarization layer 225. On the intermediate planarization layer 225, an additional light blocking layer 220-1 having a third opening OPBMa' and OPBMb' is formed, and the additional light blocking layer 220-1 is covered by a planarization layer 550.

The normal center pixel located in the central area shown in FIG. 26 and the edge pixel located in the edge area shown in FIG. 27 may have the same structure up to the pixel defining layer 380, and in this case, in the case of the same color, the size and/or shape of the opening OP may also be the same.

Meanwhile, light emitting element cover insulation layers 400/501/510/511 has a uniform height Ta overall in the central area, and has a lower height Tb than the central area in the edge area. This is because at least one of the plurality of insulating layers included in light emitting element cover insulation layers 400/501/510/511 has a reduced height toward the non-display area PA (see FIG. 9). According to an embodiment, at least one of the organic films included in light emitting element cover insulation layers 400/501/510/511 may have a reduced height toward the non-display area PA, and in the embodiment of FIG. 27, it may be the organic encapsulation layer included in the encapsulation layer 400.

As the height of light emitting element cover insulation layers 400/501/510/511 decreases, the gap between the pixel defining layer 380 and the light blocking layers 220, 220-1 also narrows. The emission layer emits light through the opening OP of the pixel defining layer 380, the second opening OPBMa and OPBMb of the light blocking layer 220, and the third opening OPBMa' and OPBMb' of the additional light blocking layer 220-1. When the gap between the pixel defining layer 380 and the light blocking layers 220, 220-1 narrows, the angle of emitted light increases, which may increase the lateral brightness ratio in the edge area or cause a light leakage phenomenon. Therefore, if the size of the second opening OPBMb; (hereinafter referred to as the edge second opening of the light blocking layer 220) or the third opening OPBMb'; (hereinafter referred to as the edge third opening of the additional light blocking layer 220-1) corresponding to the edge pixel is formed to be the same as the size of the second opening OPBMa; (hereinafter referred to as the central second opening of the light blocking layer 220) or the third opening OPBMa'; (hereinafter referred to as the central third opening of the additional light blocking layer 220-1) corresponding to the center pixel, it will be seen brighter from various angles or a bright band phenomenon (see FIG. 9) will appear. However, in the embodiments of FIGS. 26 and 27, the edge second opening OPBMb is formed the same as the central second opening OPBMa, but the edge third opening OPBMb' is formed smaller than the central third opening OPBMa'. Therefore, it will not be seen brighter from various angles or a bright band phenomenon will not appear.

In the embodiments of FIGS. 26 and 27, the horizontal distance Rb-1 from the boundary of the opening OP of the pixel defining layer 380 to the boundary of the edge third opening OPBMb' is formed smaller than the horizontal distance Ra-1 from the boundary of the opening OP of the pixel defining layer 380 to the boundary of the central third opening OPBMa' so that the bright band phenomenon does not appear. In this case, the horizontal distance Rb from the boundary of the opening OP of the pixel defining layer 380 to the boundary of the edge second opening OPBMb may be the same as the horizontal distance Ra from the boundary of the opening OP of the pixel defining layer 380 to the boundary of the central second opening OPBMa. In addition, according to an embodiment, the opening OP of the pixel defining layer 380, the second opening OPBMa and OPBMb of the light blocking layer 220, and the third opening OPBMa' and OPBMb' of the additional light blocking layer 220-1 may have the same planar shape and may have a uniform horizontal distance in all planar directions.

Referring to the embodiments of FIGS. 26 and 27, as the height of light emitting element cover insulation layers 400/501/510/511 decreases in the edge area, the edge second opening OPBMb is formed the same as the central second opening OPBMa, so the phenomenon of being seen brightly in the edge area cannot be prevented through the edge second opening OPBMb. However, since the edge third opening OPBMb' located above is formed narrower, the phenomenon of being seen brightly in the edge area can be eliminated or reduced.

Meanwhile, according to an embodiment, the edge second opening OPBMb may additionally be formed narrower than the central second opening OPBMa, and in this case, the horizontal distance Rb from the boundary of the opening OP of the pixel defining layer 380 to the boundary of the edge second opening OPBMb may be formed smaller than the horizontal distance Ra from the boundary of the opening OP of the pixel defining layer 380 to the boundary of the central second opening OPBMa.

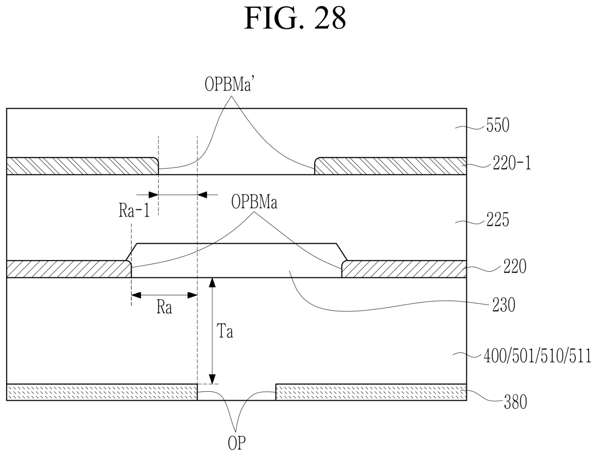

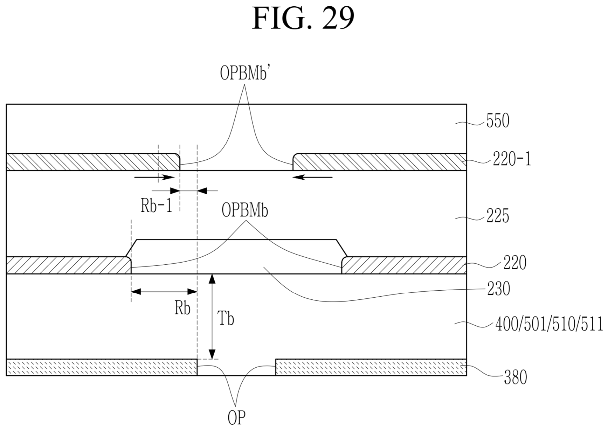

Meanwhile, the additional light blocking layer 220-1 positioned above the light blocking layer 220 may be formed to narrow the viewing angle of the light emitting display device, and may be formed with third openings OPBMa' and OPBMb' narrower than the second openings OPBMa and OPBMb of the light blocking layer 220. Such embodiments will be described with reference to FIGS. 28 and 29.

FIG. 28 is a cross-sectional view showing a second opening in a central area in a normal display area according to an embodiment, and FIG. 29 is a cross-sectional view showing a second opening in an edge area in a normal display area according to an embodiment.

The following description mainly focuses on the differences between FIG. 28, which illustrates a normal center pixel located in the central area, and FIG. 29, which illustrates an edge pixel located in the edge area, as compared with FIGS. 7, 8, 26, and 27.

FIG. 28 corresponds to FIG. 26, and FIG. 29 corresponds to FIG. 27. In FIG. 28, an additional light blocking layer 220-1 having a central third opening OPBMa' narrower than the central second opening OPBMa of the light blocking layer 220 is illustrated, and in FIG. 29, an additional light blocking layer 220-1 having a edge third opening OPBMb' narrower than the edge second opening OPBMb of the light blocking layer 220 is illustrated.

In the embodiments of FIGS. 28 and 29, the central second opening OPBMa and the edge second opening OPBMb are formed to be the same size, but the edge third opening OPBMb' is formed narrower than the edge second opening OPBMb.

In the edge area, as the height of light emitting element cover insulation layers 400/501/510/511 decreases, the gap between the pixel defining layer 380 and the light blocking layers 220, 220-1 also narrows, and the emission angle of light increases. Thus, this may increase the lateral brightness ratio of the edge area may be increased or cause light leakage. Therefore, in the embodiments of FIGS. 28 and 29, the size of the edge second opening OPBMb of the light blocking layer 220 or the edge third opening OPBMb' of the additional light blocking layer 220-1 corresponding to the edge pixel is formed narrower than the size of the central second opening OPBMa of the light blocking layer 220 or the central third opening OPBMa' of the additional light blocking layer 220-1 corresponding to the center pixel, so that the edge pixel is not viewed brighter from various angles, and the bright band phenomenon (see FIG. 9) does not appear. Specifically, in the embodiments of FIGS. 28 and 29, the edge second opening OPBMb is formed the same as the central second opening OPBMa, but the edge third opening OPBMb' is formed smaller than the central third opening OPBMa'. Here, the central third opening OPBMa' and the edge third opening OPBMb' of the additional light blocking layer 220-1 are formed narrower than the central second opening OPBMa and the edge second opening OPBMb of the light blocking layer 220, respectively. As a result, a portion of the central second opening OPBMa and the edge second opening OPBMb of the light blocking layer 220 may be covered by the additional light blocking layer 220-1.

In addition, in the embodiments of FIGS. 28 and 29, the horizontal distance Rb-1 from the boundary of the opening OP of the pixel defining layer 380 to the boundary of the edge third opening OPBMb' is formed smaller than the horizontal distance Ra-1 from the boundary of the opening OP of the pixel defining layer 380 to the boundary of the central third opening OPBMa', so that the bright band phenomenon does not appear. In this case, the horizontal distance Rb from the boundary of the opening OP of the pixel defining layer 380 to the boundary of the edge second opening OPBMb may be the same as the horizontal distance Ra from the boundary of the opening OP of the pixel defining layer 380 to the boundary of the central second opening OPBMa. Further, according to an embodiment, the opening OP of the pixel defining layer 380, the second openings OPBMa and OPBMb of the light blocking layer 220, and the third openings OPBMa' and OPBMb' of the additional light blocking layer 220-1 may have the same planar shape and may have a uniform horizontal distance in all planar directions.

Referring to the embodiments of FIGS. 28 and 29, as the height of light emitting element cover insulation layers 400/501/510/511 decreases in the edge area, the edge second opening OPBMb is formed the same as the central second opening OPBMa, so the phenomenon of being seen brightly in the edge area cannot be prevented through the edge second opening OPBMb. However, since the edge third opening OPBMb' located above is formed narrower, the phenomenon of being seen brightly in the edge area can be eliminated or reduced.

Meanwhile, according to an embodiment, the edge second opening OPBMb may additionally be formed narrower than the central second opening OPBMa. In this case, the horizontal distance Rb from the boundary of the opening OP of the pixel defining layer 380 to the boundary of the edge second opening OPBMb may be formed smaller than the horizontal distance Ra from the boundary of the opening OP of the pixel defining layer 380 to the boundary of the central second opening OPBMa.

In FIGS. 26 to 29, embodiments have been illustrated in which the size of the edge third opening formed in the edge area is smaller than that of the central third opening. However, according to an embodiment, as shown in FIG. 20, the edge third opening formed in the edge area may have a shape that is elongated toward the inside of the display area DA, that is, toward the central area. According to an embodiment, the circular shape of the third opening in the edge area may be elongated in one direction so that the third opening in the edge area has an elliptical planar shape.

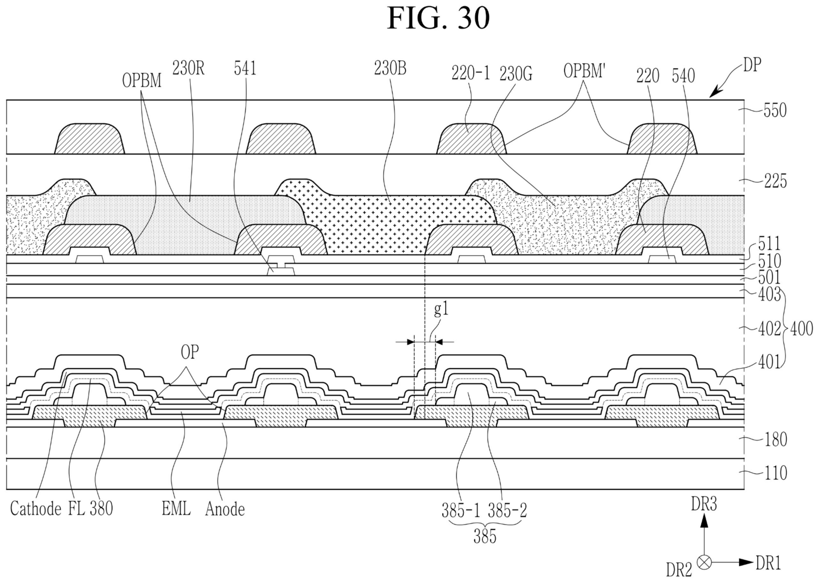

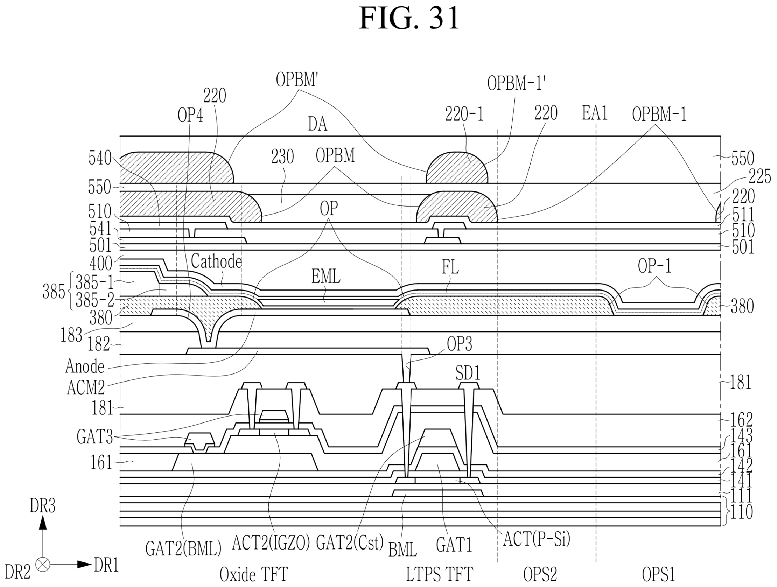

In the above description of FIGS. 26 to 29, the structure was explained mainly with respect to some layers forming the additional light blocking layer, and hereinafter, the overall structure will be described in more detail with reference to FIGS. 30 and 31.

First, the structure of the light emitting display panel DP according to an embodiment will be described with reference to FIG. 30.

FIG. 30 is a schematic cross-sectional view of a display panel according to an embodiment.

FIG. 30 corresponds to FIG. 6; however, unlike FIG. 6, an intermediate planarization layer 225 and an additional light blocking layer 220-1 are further included above the light blocking layer 220 and color filters 230R, 230G, 230B, and below the planarization layer 550.

The differences from FIG. 6 in FIG. 30 are described as follows.

An intermediate planarization layer 225 is located above the light blocking layer 220 and the color filters 230R, 230G, 230B, covering them. The intermediate planarization layer 225 planarizes the upper surface of the light blocking layer 220 and the color filters 230R, 230G, 230B, and may be a transparent organic insulator including an organic material, and the organic material may include one or more materials selected from the group consisting of polyimide, polyamide, an acryl resin, benzocyclobutene, and a phenol resin.

Above the intermediate planarization layer 225, an additional light blocking layer 220-1 having a third opening OPBM' is formed. The additional light blocking layer 220-1 may be positioned to overlap the light blocking layer 220. In the embodiment of FIG. 30, the light blocking layer 220 is formed to have a wider width than the additional light blocking layer 220-1. However, according to an embodiment, the light blocking layer 220 may be formed to have a narrower width than the additional light blocking layer 220-1.

Meanwhile, according to an embodiment, the color filters 230R, 230G, 230B may be replaced with color conversion layers or may further include color conversion layers. The color conversion layer may include quantum dots Quantum Dot.

Above the additional light blocking layer 220-1, a planarization layer 550 is located to cover it. The planarization layer 550 planarizes the upper surface of the light emitting display panel and may be a transparent organic insulator including an organic material, and the organic material may include one or more materials selected from the group consisting of polyimide, polyamide, an acryl resin, benzocyclobutene, and a phenol resin.

Depending on the embodiment, in order to improve the frontal visibility and light emission efficiency of the display panel, a low-refractive layer and an additional planarization layer may be further located on the planarization layer 550. By the low-refractive layer and the additional planarization layer having a high refractive characteristic, light may be emitted while being refracted to the front surface. In this case, depending on the embodiment, since the planarization layer 550 is omitted, a low-refractive layer and an additional planarization layer may be located on the additional light blocking layer 220-1.

In the present embodiment, a polarizing plate is not included in an upper portion of the planarization layer 550. That is, the polarizing plate may serve to prevent external light from entering and being reflected from the anode Anode or the side wall of the opening OP of the pixel defining layer 380, for example, degrading the display quality as seen by the user. However, the polarizing plate not only reduces the reflection of the external light but also reduces light emitted from the emission layer EML, so that more electrical power must be consumed in order to display a preset brightness. In order to reduce power consumption, the light emitting display device of the present embodiment may not include a polarizing plate. In addition, in the light emitting display device of the present embodiment, since the polarizing plate is not formed, the brightness is not lowered as the light emitted from the emission layer is partially absorbed by the polarizing plate, and a light emitting display device with the maximum brightness value of 2500 nits or more may be provided.

In addition, the present embodiment already includes the structure in which the degree of reflection from the anode Anode is reduced by covering a side surface of the anode Anode by the pixel defining layer 380, and the degree of incident light is reduced by forming the light blocking layer 220, so that the degradation of display quality due to reflection is prevented. Therefore, the polarizing plate may not be separately formed on the front surface of the light emitting display panel DP.

The plurality of pixels may be located in the display area DA of the light emitting display device to display images, and one pixel may include at least two of red (R), green (G), and blue (B) subpixels. The display area DA includes a minimum unit pixel including red (R), green (G), and blue (B) subpixels, each by at least one, and the minimum unit pixel may have an elliptical shape with a different eccentricity and/or major axis direction of the ellipse from the openings OP, OPBM and OPBM' corresponding to the adjacent minimum unit pixel. In addition, the minimum unit pixel may be located within a square or a similar area in the display area DA. A plurality of minimum unit pixels may be included to form the repeated unit pixels, and the repeated unit pixels may be formed by being repeated within an entire area of the display area DA. The repeated unit pixels may have an elliptical shape with the same eccentricity and major axis direction of the ellipse as the openings OP, OPBM and OPBM' corresponding to the adjacent repeated unit pixels. The repeated unit pixels may also be located within a square or a similar area in the display area DA, but may have a larger area than the area in which the minimum unit pixel is formed.

Hereinafter, the stacking structure of the display area DA and the first component area EA1 will be described in more detail, with reference to FIG. 31.

FIG. 31 is a cross-sectional view of a light emitting display device according to an embodiment.

FIG. 31 corresponds to FIG. 24; however, unlike FIG. 24, an intermediate planarization layer 225 and an additional light blocking layer 220-1 are further included above the light blocking layer 220 and the color filters 230, and below the planarization layer 550.

The differences from FIG. 24 in FIG. 31 are described as follows.

An intermediate planarization layer 225 is located above the light blocking layer 220 and the color filters 230, covering them. The intermediate planarization layer 225 is formed to extend not only over the display area DA but also over the first component area EA1.

An additional light blocking layer 220-1 is located above the intermediate planarization layer 225.

The additional light blocking layer 220-1 includes a third opening OPBM' positioned in the display area DA and an additional third opening OPBM-1' positioned in the first component area EA1. The additional light blocking layer 220-1 may be positioned to overlap the light blocking layer 220. In the embodiment of FIG. 31, the light blocking layer 220 is formed to have a wider width than the additional light blocking layer 220-1. However, in other embodiments, the light blocking layer 220 may be formed to have a narrower width than the additional light blocking layer 220-1.

Meanwhile, depending on the embodiment, the color filters 230R, 230G, and 230B may be replaced with color conversion layers, or may further include color conversion layers. The color conversion layer may include quantum dots.

A planarization layer 550 is located above the additional light blocking layer 220-1, covering it. Depending on the embodiment, in order to improve the frontal visibility and light emission efficiency of the display device, a low-refractive layer and an additional planarization layer may be further located on the planarization layer 550. By the low-refractive layer and the additional planarization layer having a high-refractive characteristic, light may be emitted while being refracted to the front surface. In this case, depending on the embodiment, since the planarization layer 550 is omitted, a low-refractive layer and an additional planarization layer may be located on the additional light blocking layer 220-1.

In the present embodiment, a polarizing plate is not included in the upper portion of the planarization layer 550. That is, the polarizing plate may serve to prevent the display quality from being degraded when external light is incident and reflected from the anode Anode and the user recognizes it. However, the present embodiment already includes the structure in which the degree of reflection from the anode Anode is reduced by covering the side surface of the anode Anode by the pixel defining layer 380, and the degree of incident light is reduced by forming the light blocking layer 220, so that the degradation of display quality due to reflection is prevented. Therefore, the polarizing plate may not be separately formed on the front surface of the display panel DP.

Meanwhile, in FIG. 31, in addition to the stacking structure of the display area DA, a cross-section structure of the first component area EA1 that is formed so that light may pass through a portion of the display area DA is illustrated.

In FIG. 31, the first component area EA1 is divided into a first photosensor area OPS1 (also referred to as a transmissive photosensor area) and a second photosensor area OPS2 (also referred to as a non-transmissive photosensor area). Here, the first photosensor area OPS1 is formed so that light can pass through by providing additional openings OP-1, OPBM-1, OPBM-1' in the pixel defining layer 380, the light blocking layer 220, and the additional light blocking layer 220-1, so that the first photosensor area OPS1 do not overlap in the plane with the pixel defining layer 380, the light blocking layer 220, and the additional light blocking layer 220-1. On the other hand, the second photosensor area OPS2 is formed to overlap the pixel defining layer 380 in a plan view so that light cannot pass through. According to an embodiment, the second photosensor area OPS2 may overlap not only with the pixel defining layer 380 but also additionally with the light blocking layer 220 and the additional light blocking layer 220-1in a plan view. The first photosensor area OPS1 and the second photosensor area OPS2 of the first component area EA1 may not include layers that block light, such as a metal layer or a semiconductor layer. For reference, the first optical element ES1 (see FIG. 2) may be located on the back surface of the first component area EA1, and may sense the front surface of the light emitting display device through the first photosensor area OPS1 located in the first component area EA1.

Specifically, the layered structure of the first component area EA1 is as follows.

Above the substrate 110, an inorganic insulating buffer layer 111 is located, and a first gate insulating layer 141 and a second gate insulating layer 142, both inorganic insulating layers, are sequentially located above the inorganic insulating buffer layer 111. In addition, on the second gate insulating layer 142, a first interlayer insulating layer 161, a third gate insulating layer 143, and a second interlayer insulating layer 162, which are all inorganic insulating layers, are sequentially stacked. On the second interlayer insulating layer 162, a first organic film 181, a second organic film 182, and a third organic film 183, which are organic insulating films, are sequentially stacked. On the third organic film 183, a functional layer FL may be located, and a cathode Cathode may be located thereon. On the cathode Cathode, an encapsulation layer 400 is located, and sensing insulating layers 501, 510, 511 are sequentially located thereon. The encapsulation layer 400 may have a triple-layer structure sequentially including an inorganic encapsulation layer, an organic encapsulation layer, and an inorganic encapsulation layer. Further, the sensing insulating layers 501, 510, 511 may all be inorganic insulating layers. Above the sensing insulating layers 501, 510, 511, the intermediate planarization layer 225 and the planarization layer 550 may be located.

The metal layer, the first semiconductor layer, the first gate conductive layer, the second gate conductive layer, the oxide semiconductor layer, the third gate conductive layer, the first data conductive layer, the second data conductive layer, and the anode Anode are not located in the first component area EA1 described above. In addition, the emission layer EML, and the sensing electrodes 540 and 541 are not formed.

In addition, in the first photosensor area OPS1 in the first component area EA1, each of the additional openings OP-1, OPBM-1, and OPBM-1' are formed in the pixel defining layer 380, the light blocking layer 220, and additional light blocking layer 220-1, respectively, so that the pixel defining layer 380, the light blocking layer 220, and additional light blocking layer 220-1 may not be formed. As a result, light may pass through the first photosensor area OPS1. In contrast, the second photosensor area OPS2 in the first component area EA1 may have a structure that does not have the additional openings OP-1 of the pixel defining layer 380, and thus does not transmit light through the pixel defining layer 380.

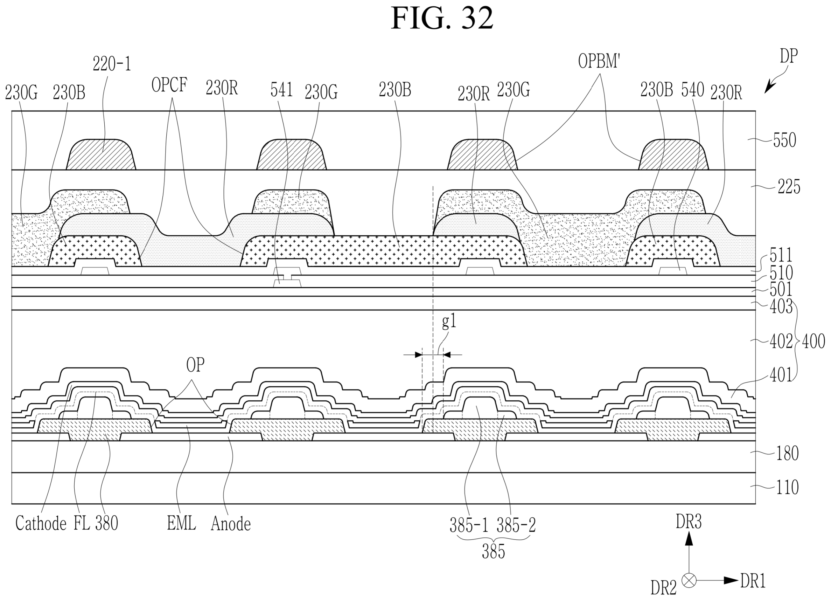

Meanwhile, according to an embodiment, the light blocking layer 220 and the additional light blocking layer 220-1 may not both be included, and at least one of them may instead be formed as a light shielding area of color filters where at least two of the color filters 230R, 230G, and 230B overlap. Hereinafter, with reference to FIG. 32, an embodiment will be described in which one of the light blocking layers is not included, and instead a light shielding area of color filters is formed by the overlap of at least two of the color filters 230R, 230G, and 230B.

FIG. 32 is a schematic cross-sectional view of a display panel according to an embodiment.

FIG. 32 corresponds to FIG. 30 and, in comparison with FIG. 30, forms a light shielding area of color filters by overlapping at least two color filters to block visible light instead of the light blocking layer 220.

In the embodiment of FIG. 32, the light shielding area of color filters that blocks visible light by overlapping at least two color filters is formed by the overlap of all three color filters. However, in other embodiments, as shown in FIG. 22, the light shielding area may be formed by the overlap of two color filters.

In the embodiment of FIG. 32, the blue color filter 230B, the red color filter 230R, and the green color filter 230G are sequentially stacked, but the stacking order of the color filters may be variously modified depending on the embodiment.

In addition, in the embodiment of FIG. 32, no polarizer is formed on the front surface of the light emitting display panel DP. Instead, the pixel defining layer 380 is formed of a black organic material, and a light shielding area at least two or more is formed above the pixel defining layer 380 by overlapping at least two color filters, thereby preventing external light, even if incident into the panel, from being reflected at the anode or other components and transmitted to the user.

Specifically, color filters 230R, 230G, and 230B are disposed above the third sensing insulating layer 511. The color filters 230R, 230G, and 230B include a red color filter 230R that transmits red light, a green color filter 230G that transmits green light, and a blue color filter 230B that transmits blue light. Each of the color filters 230R, 230G, and 230B may be positioned to overlap the anode of the light emitting diode in a plan view. Light emitted from the emission layer EML passes through the color filters and is converted into the corresponding color before being emitted, so that all of the light emitted from the emission layer EML may have the same color. However, the emission layer EML may emit light of different colors, and by allowing such light to pass through the corresponding color filters of the same color, the displayed color sensation may be enhanced.

In regions other than the light shielding areas, only a single color filter may be located, and light of the color corresponding to that color filter passes therethrough to form the transmitting region of the color filter. Hereinafter, the transmitting region of the color filter where only one color filter is located is referred to as the second opening OPCF of the light shielding area, since light is transmitted therethrough. The second opening OPCF of the light shielding area is an opening located in the light shielding area where at least two color filters overlap, and may correspond to a region where only one color filter is located. Meanwhile, the second opening OPCF of the light shielding area may correspond to the second opening OPBM of the light blocking layer 220 described above.

The area of the second opening OPCF of the light shielding area is formed larger than the opening OP of the pixel defining layer 380, and in a plan view, the opening OP of the pixel defining layer 380 may be located within the second opening OPCF of the light shielding area.

In addition, one side of the spacer 385 is disposed inwardly from the corresponding side of the pixel defining layer 380 by a predetermined interval g1, and the spacer 385 is also disposed inwardly with respect to one side of the light shielding area. As a result, when viewed from the front of the display panel DP, the spacer 385 may not be visible as it is hidden by the light shielding area.

According to an embodiment, the color filters 230R, 230G, and 230B may be replaced with a color conversion layer or may further include a color conversion layer. The color conversion layer may include quantum dots.

On the color filters 230R, 230G, and 230B, an intermediate planarization layer 225 covering them is positioned. The intermediate planarization layer 225 is for planarizing the upper surface of the color filters 230R, 230G, and 230B, and may be a transparent organic insulating film including one or more materials selected from the group consisting of polyimide, polyamide, acrylic resin, benzocyclobutene, and phenol resin.

On the intermediate planarization layer 225, an additional light blocking layer 220-1 having a third opening OPBM' is formed. The additional light blocking layer 220-1 may be located to overlap with the light shielding area of the overlapped color filters. In the embodiment of FIG. 30, the light shielding area of the overlapped color filters is formed wider than the additional light blocking layer 220-1. However, depending on the embodiment, the light shielding area of the overlapped color filters may be formed narrower than the additional light blocking layer 220-1.

Meanwhile, according to an embodiment, the color filters 230R, 230G, and 230B may be replaced with a color conversion layer or may further include a color conversion layer. The color conversion layer may include quantum dots.

A planarization layer 550 covering the additional light blocking layer 220-1 is disposed above the additional light blocking layer 220-1. The planarization layer 550 serves to planarize the upper surface of the light emitting display panel, and may be a transparent organic insulating film including one or more materials selected from the group consisting of polyimide, polyamide, acrylic resin, benzocyclobutene, and phenol resin.

According to an embodiment, a low refractive layer and an additional planarization layer may be further disposed above the planarization layer 550 to improve the front visibility and light emission efficiency of the display panel. By means of the low refractive layer and the additional planarization layer having high refractive properties, the emitted light can be refracted and discharged toward the front. In this case, according to an embodiment, the planarization layer 550 may be omitted, and the low refractive layer and the additional planarization layer may be positioned directly on the additional light blocking layer 220-1.

In this embodiment, a polarizer is not included on the upper portion of the planarization layer 550. That is, a polarizer can serve to prevent degradation of display quality caused by external light being incident and reflected at the anode Anode or sidewalls of the opening OP of the pixel defining layer 380 and then being perceived by the user. However, a polarizer not only reduces external light reflection but also reduces the light emitted from the emission layer EML, thereby consuming more power to display a certain luminance. To reduce power consumption, the light emitting display device of this embodiment may not include a polarizer.

In addition, since the light emitting display device of this embodiment does not form a polarizer, the light emitted from the emission layer is not partially absorbed by the polarizer, and thus the luminance does not decrease, allowing the provision of a light emitting display device having a maximum luminance value of 2500 nits or more.

Furthermore, in this embodiment, the pixel defining layer 380 covers the side surface of the anode Anode to reduce the degree of reflection from the anode, and a light shielding area of the overlapped color filters is also formed to reduce the incidence of light, thereby preventing deterioration of display quality due to reflection. Therefore, it is not necessary to separately form a polarizer on the front surface of the light emitting display panel DP.

Features of the embodiment of Figure 32 can be applied to the various embodiments described above. For example, in the embodiments of Figures 26 to 29, instead of the light blocking layer 220, a light blocking area blocking visible light is formed by overlapping at least two or more color filters, and the additional light blocking layer 220-1 may be formed thereon.

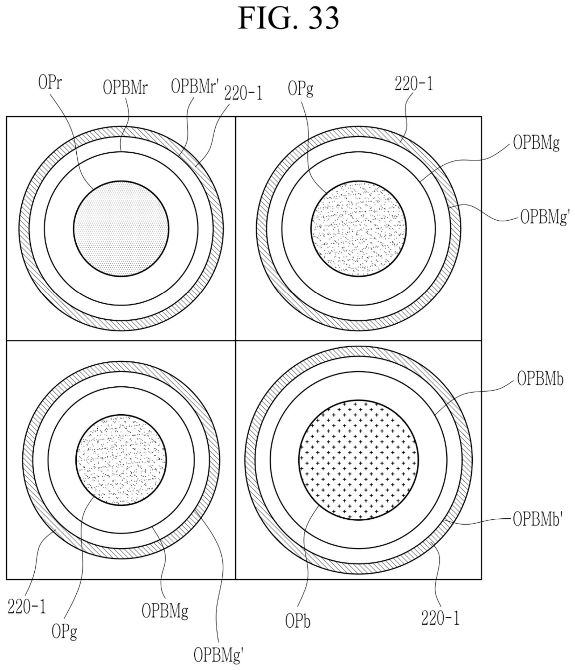

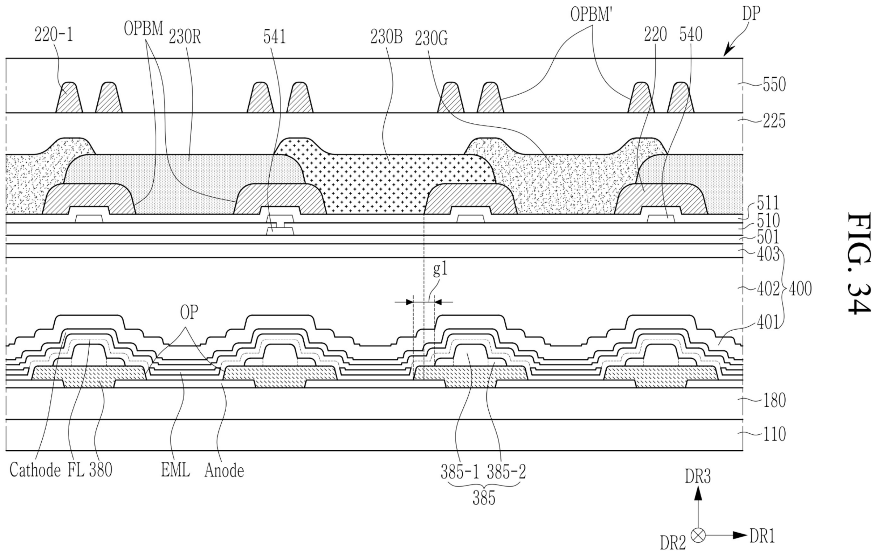

Meanwhile, according to an embodiment, the additional light blocking layer 220-1 may be formed in a ring shape by being located only around the third opening OPBM' in the plane. Such embodiments will be described with reference to FIGS. 33 and 34.

FIG. 33 is a top plan view of a display panel according to an embodiment, and FIG. 34 is a schematic cross-sectional view of a display panel according to an embodiment of FIG. 33.

First, FIG. 33 will be described.

FIG. 33 illustrates the planar structure of a pixel located in the display area DA according to an embodiment. In FIG. 33, the openings OPr, OPg, OPb of the pixel defining layer 380, the second openings OPBMr, OPBMg, OPBMb of the light blocking layer 220, and the third openings OPBMr', OPBMg', OPBMb' of the additional light blocking layer 220-1 are illustrated, as well as the portions where the additional light blocking layer 220-1 is formed with hatching. Specifically, in FIG. 33, the pixel defining layer 380 is located outside each opening OPr, OPg, OPb, and the light blocking layer 220 is located outside each second opening OPBMr, OPBMg, OPBMb. The additional light blocking layer 220-1 is located only in the hatched regions, and has a ring-shaped planar form. A plurality of additional light blocking layers 220-1 are formed separately from one another. Inside the ring shape of the additional light blocking layer 220-1, the third openings OPBMr', OPBMg', OPBMb' of the additional light blocking layer 220-1 are located, and outside the ring shape, no additional light blocking layer 220-1 is formed. The third openings OPBM' of the additional light blocking layer 220-1 overlap the second openings OPBM of the light blocking layer 220, and in the plane, the additional light blocking layers 220-1 are positioned around the second openings OPBM of the light blocking layer 220. Although no additional light blocking layer 220-1 is positioned between adjacent additional light blocking layers 220-1, a light-shielding structure in which light cannot pass is formed by the underlying light blocking layer 220.

The planar structure of FIG. 33 corresponds to the pixels of the display area DA, and in the edge area, it may be modified as in at least one of the various embodiments described above. As a specific example, as shown in FIG. 27 or FIG. 29, the edge third openings may be formed narrower than the central third openings. Meanwhile, according to another embodiment, as shown in FIG. 20, the edge third opening formed in the edge area may have a shape elongated toward the center of the display area DA, i.e., toward the central area. In some embodiments, the circular shape of the third opening in the edge area may be elongated in one direction so that the third opening in the edge area has an elliptical planar shape.

The display panel having the planar structure of FIG. 33 may have a cross-sectional structure as shown in FIG. 34.

FIG. 34 corresponds to FIG. 30, with the difference being only in the cross-sectional structure of the additional light blocking layer 220-1. The specific structure of the additional light blocking layer 220-1, which differs from FIG. 30, is described below.

Referring to FIG. 34, the intermediate planarization layer 225 has a third opening OPBM', and the cross-sectional structure of the plurality of additional light blocking layers 220-1 having a ring shape is illustrated. Since one additional light blocking layer 220-1 has a ring shape around the third opening OPBM', in FIG. 33, one additional light blocking layer 220-1 is located on both sides of the third opening OPBM'. Above the light blocking layer 220, adjacent additional light blocking layers 220-1 are positioned, and are formed spaced apart at a predetermined distance. Although no additional light blocking layer 220-1 is located between adjacent additional light blocking layers 220-1, a light-shielding structure in which light cannot pass is formed by the underlying light blocking layer 220. The widths between adjacent additional light blocking layers 220-1 may be formed in various ways, and in some embodiments, adjacent additional light blocking layers 220-1 may be connected to each other.

In the embodiments of FIGS. 33 and 34, the additional light blocking layer 220-1 is formed narrower than the light blocking layer 220, and in the plane, the additional light blocking layer 220-1 is formed only at positions where the light blocking layer 220 is formed. However, in some embodiments, at least a portion of the additional light blocking layer 220-1 may be positioned outside the light blocking layer 220 in the plane.

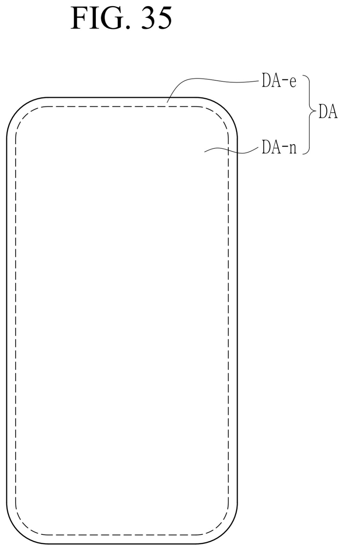

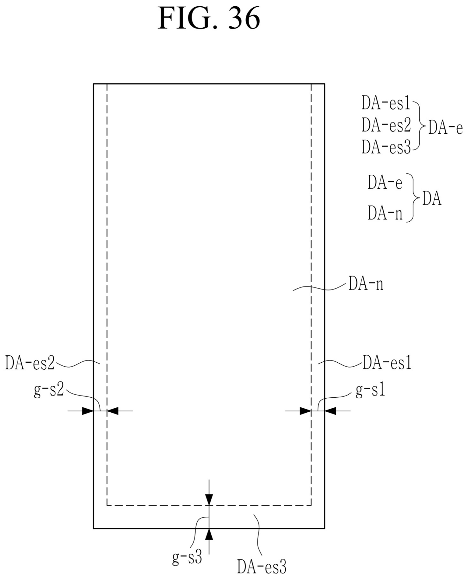

Hereinafter, various embodiments regarding the positions of the central area and the edge area within the display area DA will be described with reference to FIGS. 35 and 36.

FIG. 35 and FIG. 36 are top plan views of a display area of a display panel according to an embodiment.

In FIGS. 35 and 36, only the display area DA of the display panel is illustrated, and the non-display area is not illustrated. In FIGS. 35 and 36, the display area DA is divided into a central area DA-n and an edge area DA-e.

First, the embodiment of FIG. 35 will be described.

In FIG. 35, the edge area DA-e is located along all edges of the display area DA, and the central area DA-n is located inside the edge area DA-e. The edge area DA-e is a region where the height of light emitting element cover insulation layers (see 400/501/510/511 of FIGS. 7 and 8) is lower than that of the central area DA-n. The edge area DA-e may be located within a range of about 3 mm or less inward from the outermost edge of the display area DA. Depending on the embodiment, the width of the edge area may be narrower.

The difference between the edge area DA-e and the central area DA-n may reflect at least one of the features of the various embodiments described above, so that the bright band phenomenon, in which the edge area DA-e appears bright, may not occur.

Meanwhile, in some embodiments, the edge area DA-e may not be located along all edges of the display area DA. One such embodiment is illustrated in FIG. 36.

In the embodiment of FIG. 36, the edge area DA-e is located only along both side edges and the lower edge of the display area DA, and not along the upper edge, and may be located at the corners of the display area DA.

Specifically, the edge area DA-e is composed of a first edge area DA-es1 located on the right side of the display area DA, a second edge area DA-es2 located on the left side of the display area DA, and a third edge area DA-es3 located on the lower side of the display area DA.

Here, the first edge area DA-es1 has a first width g-s1, the second edge area DA-es2 has a second width g-s2, and the third edge area DA-es3 has a third width g-s3. In this embodiment, the first width g-s1 and the second width g-s2 may have the same value, and the third width g-s3 has a larger value than the first width g-s1 and the second width g-s2.

In the display area DA of the embodiment of FIG. 36, each boundary portion may have the features as shown in Table 1 below.

**[Table 1]**

| | Area 1 | Area 2 | Area 3 | Area 4 | Area 4-1 | Area 5 |
|---|---|---|---|---|---|---|
| distance from edge | 0~200 *µ*m | 200~40 0*µ*m | 400∼600 *µ*m | 600∼800 *µ*m | 800∼1000 *µ*m | 1000µm ∼ |
| Lower boundary BMPB (*µ*m) | 3.36 | 4.0 | 4.52 | 4.99 | 4.99+5.30 1:1 ratio | 5.30 |
| Left boundary BMPB (*µ*m) | 3.36 | 4.0 | 4.8 | 5.30 | 5.30 | 5.30 |
| Right boundary BMPB (*µ*m) | 3.36 | 4.0 | 4.8 | 5.30 | 5.30 | 5.30 |
| Upper boundary BMPB (*µ*m) | 5.30 | 5.30 | 5.30 | 5.30 | 5.30 | 5.30 |

Table 1 corresponds to FIG. 19, and in Table 1, the horizontal distance BMPB from the boundary of the opening OP of the pixel defining layer 380 to the boundary of the edge third opening OPBMb' in specific regions of the display area DA of FIG. 36 is also described. In one region, all of the edge third openings OPBMb' may have the same horizontal distance BMPB. In addition, in Table 1, the lower boundary represents the third edge area DA-es3 of FIG. 36 and the central area adjacent thereto, the left boundary represents the second edge area DA-es2 of FIG. 36 and the central area adjacent thereto, the right boundary represents the first edge area DA-es1 of FIG. 36 and the central area adjacent thereto, and the upper boundary represents only the central area located at the upper side since the embodiment of FIG. 36 does not include an edge area at the upper side. In Table 1, the region in which the value of the horizontal distance BMPB is shown as 5.30 is the central area, and the regions having values smaller than 5.30 may correspond to the edge areas.

Although Table 1 does not describe the thickness difference of light emitting element cover insulation layers 400/501/510/511 occurring in the edge area, it may correspond to the thickness difference of FIG. 19. Depending on the embodiment, the edge area may be formed with a width greater than about 1 mm and with a width of about 3 mm or less.

In the lower boundary portion of Table 1, as in FIG. 19, an additional region Area 4-1 is further included between the fourth region Area 4 and the fifth region Area 5. The additional region Area 4-1 is formed by alternately arranging the two regions located on both sides, that is, the fourth region Area 4 and the fifth region Area 5, in a 1:1 ratio. In Table 1, the additional region Area 4-1 includes, in a 1:1 ratio, the edge second openings OPBMb formed in each of the two adjacent regions Area 4 and Area 5, but depending on the embodiment, the ratio may be adjusted.

When the boundary is formed as in Table 1, the bright band phenomenon in the edge area may not occur.

The embodiment of FIG. 36 may have a structure in which a pad portion is located in a non-display area PA at the lower side of the display area DA, and the pad portion is electrically connected to a flexible printed circuit board (FPCB) including a driving chip. Since the pad portion is located in the non-display area PA at the lower side of the display area DA, the width of the region where the height of light emitting element cover insulation layers (see 400/501/510/511 of FIGS. 7 and 8) decreases becomes larger, and accordingly, the third edge area DA-es3 located on the lower side of the display area DA may be formed to have a larger width than the other edge areas.

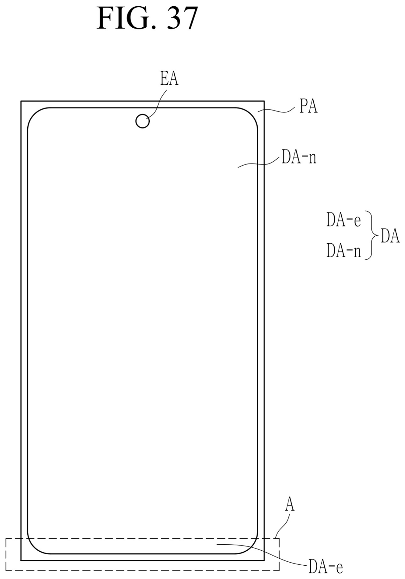

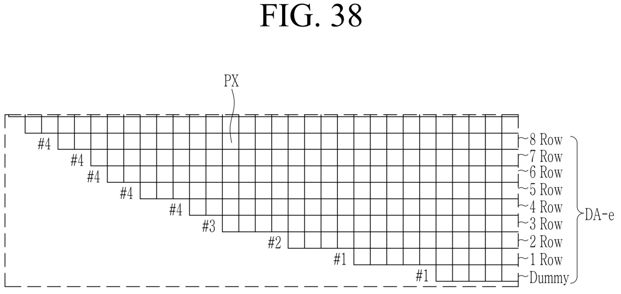

Hereinafter, the detailed structure of the edge area located at the lower side of the display area DA will be described in more detail with reference to FIGS. 37 and 38.

FIG. 37 is a top plan view of a display panel according to an embodiment, and FIG. 38 is an enlarged top plan view of a part of a display panel according to an embodiment of FIG. 37.

In FIG. 37, in addition to the display area DA, a non-display area PA, and a component area EA are illustrated, and the edge area DA-e of the display area DA is located at the lower side. Depending on the embodiment, the edge area may also be located at other edge portions of the display area DA, and the display area DA other than the edge area DA-e may be the central area DA-n.

FIG. 38 is an enlarged view of a portion of area A shown in FIG. 37, and schematically shows the pixel arrangement of the edge area DA-e including dummy pixels.

In the embodiment of FIG. 38, the edge area DA-e is composed of a dummy pixel row Dummy and eight pixel rows, and the pixel structures formed in each pixel row are schematically shown as #1, #2, #3, and #4. Here, #1, #2, #3, and #4 each have different pixel structures and may correspond to the respective Areas described in FIGS. 16 to 18. That is, #1 may have the structure of Area 1, #2 may have the structure of Area 2, #3 may have the structure of Area 3, and #4 may have the structure of Area 4. Specifically, the first pixel row 1 Row has the structure of Area 1, the second pixel row 2 Row has the structure of Area 2, the third pixel row 3 Row has the structure of Area 3, the fourth pixel row 4 Row has the structure of Area 4, the fifth pixel row 5 Row has the structure of Area 4, the sixth pixel row 6 Row has the structure of Area 4, the seventh pixel row 7 Row has the structure of Area 4, and the eighth pixel row 8 Row has the structure of Area 4. In addition, in the embodiment of FIG. 38, the dummy pixel row Dummy may have the same structure of Area 1 as the adjacent first pixel row 1 Row.

Meanwhile, depending on the embodiment, #1, #2, #3, and #4 may have structures different from those of FIGS. 16 to 19, and may have the structures of FIG. 20 or FIGS. 26 to 29. In this case, the #1 located at the edge may have a structure that reduces light leakage compared to the #4 located inside.

Meanwhile, according to an embodiment, the various embodiments described above may be combined. For example, when the embodiments of FIGS. 37 and 38 are combined with the embodiments of FIGS. 33 and 34, the first to eighth pixel rows may have the third openings of the additional light blocking layer 220-1 as shown in Table 2 below.

**[Table 2]**

| | 1 Row | 2 Row | 3 Row | 4 Row | 5 Row | 6 Row | 7 Row | 8 Row |
|---|---|---|---|---|---|---|---|---|
| Inner diameter difference | -1.0 | -0.6 | -0.4 | -0.1 | -0.1 | -0.1 | -0.1 | -0.1 |
| Outer diameter difference | +0.5 | +0.2 | 0 | 0 | 0 | 0 | 0 | 0 |

The additional light blocking layer 220-1 has a ring shape, and in Table 2, the inner diameter represents the diameter of the third opening of the ring-shaped additional light blocking layer 220-1, while the outer diameter represents the outer diameter of the additional light blocking layer 220-1. The values listed in Table 2 are in micrometers (µm) and show the differences between the values in the central area and the edge area.

For example, in Table 2, the additional light blocking layer 220-1 located in the first pixel row 1 Row is formed such that the diameter of the edge third opening is smaller by 1.0 µm compared to the diameter of the central third opening, and the outer diameter of the additional light blocking layer 220-1 may be formed larger by 0.5 µm than the outer diameter of the additional light blocking layer 220-1 located in the central area. That is, according to Table 2, as the diameter of the edge third opening decreases further from the central area, light leakage in the edge area can be reduced.

While this disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims.

### <Description of symbols>

| | | | |
|---|---|---|---|
| 220, 220-1: | light blocking layer | 380: | pixel defining layer |
| OP, OPr, | OPg, OPb: opening of pixel defining layer | | |
| OPBM, | OPBM': opening of light blocking layer | | |
| 230R, 230G, 230B: | color filter | | |
| OPCF: | second opening of color filter | | |
| Anode: | anode | Cathode: | cathode |
| EML: | emission layer | FL: | functional layer |
| 1000: | display device | DP: | display panel |
| 110: | substrate | 180, 181, 182, 183: | organic layer |
| 141, 142, 143: | gate insulation layer | | |
| 161, 162: | interlayer insulation layer | | |
| 385, 385-1, 385-2: | spacer | | |
| 400, 401, 402, 403: | encapsulation layer | | |
| 501, 510, 511: | sensing insulation layer | | |
| 540, 541: | sensing electrode | | |
| 225, 550: | planarization layer | DA, DA1-1, DA1-2: | display area |
| EA, EA1, EA2: | component area | OPBMa: | central second opening OPBMb, OPBMrb1, OPBMgb1, OPBMbb1, OPBMrb2, OPBMgb2, and |
| OPBMbb2: | edge second opening | | |
| OPBMa': | central third opening | OPBMb': | edge third opening |
| LCI, 400/501/510/511: | light emitting element cover insulation layer | | |

Further Embodiments are set out in the following clauses:
Clause 1. A light emitting display device, comprising:
   a substrate comprising a normal display area divided into an edge area and a central area;
   an anode located on the substrate;
   a pixel defining layer comprising a first opening configured to extend to at least a portion of the anode;
   an emission layer located within the first opening of the pixel defining layer;
   a cathode configured to cover the pixel defining layer and the emission layer;
   an encapsulation layer configured to cover the cathode and comprising an organic encapsulation layer; and
   a second opening located on the encapsulation layer, and corresponding to the first opening of the pixel defining layer,
   wherein the second opening is divided into a central second opening located in the central area and an edge second opening located in the edge area, and
   wherein the edge second opening is smaller than the central second opening.
Clause 2. The light emitting display device of clause 1, wherein:
   the edge second opening is formed so that a horizontal distance from a boundary of the first opening corresponding to the edge second opening to a boundary of the edge second opening is smaller than a horizontal distance from the boundary of the first opening corresponding to the central second opening to a boundary of the central second opening.
Clause 3. The light emitting display device of clause 1 or clause 2, wherein the edge area is located within a range of 3 mm or less inward from an outermost edge of the display area.
Clause 4. The light emitting display device of clause 3, wherein the edge area is located within a range of 1 mm or less inward from the outermost edge of the display area.
Clause 5. The light emitting display device of clause 3 or clause 4, wherein the edge area is located on a flat surface of the substrate.
Clause 6. The light emitting display device of any preceding clause, wherein:
   the edge area is divided into a plurality of areas; and
   edge second openings located in a same area among the plurality of areas and corresponding to a same color pixel have a same size.
Clause 7. The light emitting display device of clause 6, wherein:
   an edge second opening of an area located closest to an outermost edge of the display area, among the plurality of areas of the edge area, is smallest of the edge second openings, and an edge second opening of an area farthest from the outermost edge of the display area is largest of the edge second openings, and edge second openings in areas located sequentially inward from the outermost edge of the display area gradually increases.
Clause 8. The light emitting display device of clause 7, wherein an additional area located between two adjacent areas among the plurality of areas of the edge area comprises edge second openings located in each of two areas located on either side of the additional area.
Clause 9. The light emitting display device of clause 8, wherein the additional area comprises the edge second openings formed in each of two areas located on either side of the additional area in a 1:1 ratio.
Clause 10. The light emitting display device of any one of clauses 6 - 9, wherein:
   the first opening and the second opening of the display area each have a circular planar shape; and
   the first opening and the second opening corresponding to each other have centers at the same position in a plan view.
Clause 11. The light emitting display device of any one of clauses 6 - 10, wherein the first opening and/or the second opening located in the same area among the plurality of areas of the edge area and corresponding to different colors have different sizes.
Clause 12. The light emitting display device of any one of clauses 6 - 11, wherein the edge second opening in the edge area has a planar shape extending toward an inner side of the display area.
Clause 13. The light emitting display device of clause 12, wherein:
   the edge area is located along four sides of the display area;
   extending directions along which the edge second opening is elongated from the edge area located on each side are the same; and
   the extending directions along which the edge second opening extends in the entire edge area are four in total.
Clause 14. The light emitting display device of any preceding clause, wherein the second opening is located in a light blocking layer located in an upper portion of the pixel defining layer, or an overlapping light shielding area of a color filter.
Clause 15. A light emitting display device, comprising:
   a substrate comprising a normal display area divided into an edge area and a central area;
   an anode located on the substrate;
   a pixel defining layer comprising a first opening configured to extend to at least a portion of the anode;
   an emission layer located within the first opening of the pixel defining layer;
   a cathode configured to cover the pixel defining layer and the emission layer;
   an encapsulation layer configured to cover the cathode and comprising an organic encapsulation layer; and
   a second opening located on the encapsulation layer, and corresponding to the first opening of the pixel defining layer,
   wherein the second opening is divided into a central second opening located in the central area and an edge second opening located in the edge area, and
   wherein the edge second opening in the edge area has a planar shape extending toward an inner side of the display area.
Clause 16. The light emitting display device of clause 15, wherein:
   the edge area is located along four sides of the display area;
   extending directions along which the edge second opening is elongated from the edge area located on respective sides are the same; and
   the extending directions along which the edge second opening extends in the entire edge area are four in total.
Clause 17. The light emitting display device of clause 15 or clause 16, wherein the second opening is located in a light blocking layer located in an upper portion of the pixel defining layer, or an overlapping light shielding area of a color filter.
Clause 18. An electronic device comprising a light emitting display device, wherein the light emitting display device comprises:
   a substrate comprising a normal display area divided into an edge area and a central area;
   an anode located on the substrate;
   a pixel defining layer comprising a first opening configured to extend to at least a portion of the anode;
   an emission layer located within the first opening of the pixel defining layer;
   a cathode configured to cover the pixel defining layer and the emission layer;
   an encapsulation layer configured to cover the cathode and comprising an organic encapsulation layer; and
   a second opening located on the encapsulation layer, and corresponding to the first opening of the pixel defining layer,
   wherein the second opening is divided into a central second opening located in the central area and an edge second opening located in the edge area, and
   wherein the edge second opening is smaller than the central second opening.
Clause 19. The electronic device of clause 18, wherein the edge second opening is formed so that a horizontal distance from a boundary of the first opening corresponding to the edge second opening to a boundary of the edge second opening is smaller than a horizontal distance from the boundary of the first opening corresponding to the central second opening to a boundary of the central second opening.
Clause 20. The electronic device of clause 18 or clause 19, wherein:
   the edge area is divided into a plurality of areas; and
   edge second openings located in a same area among the plurality of areas and corresponding to a same color pixel have a same size.

## Claims

1. A light emitting display device (1000), comprising:
a substrate (110) comprising a normal display area (DA) divided into an edge area and a central area;
an anode (Anode) located on the substrate (110);
a pixel defining layer (380) comprising a first opening (OP) configured to expose at least a portion of the anode (Anode);
an emission layer (EML) located within the first opening (OP) of the pixel defining layer (380);
a cathode (Cathode) configured to cover the pixel defining layer (380) and the emission layer (EML);
an encapsulation layer (400) configured to cover the cathode (Cathode) and comprising an organic encapsulation layer (402); and
a second opening (OPBM) located on the encapsulation layer (400), and corresponding to the first opening (OP) of the pixel defining layer (380),
wherein the second opening (OPBM) is divided into a central second opening (OPBMa) located in the central area and an edge second opening (OPBMb) located in the edge area, and
wherein the edge second opening (OPBMb) is smaller than the central second opening (OPBMa).

2. The light emitting display device (1000) of claim 1, wherein:
the edge second opening (OPBMb) is formed so that a horizontal distance (Rb) from a boundary of the first opening (OP) corresponding to the edge second opening (OPBMb) to a boundary of the edge second opening (OPBMb) is smaller than a horizontal distance (Ra) from the boundary of the first opening (OP) corresponding to the central second opening (OPBMa) to a boundary of the central second opening (OPBMa).

3. The light emitting display device (1000) of claim 1 or claim 2, wherein the edge area is located within a range of about 3 mm or less inward from an outermost edge of the display area (DA)
wherein, optionally, the edge area is located within a range of about 1 mm or less inward from the outermost edge of the display area (DA).

4. The light emitting display device (1000) of claim 3, wherein the edge area is located on a flat surface of the substrate (101).

5. The light emitting display device (1000) of any preceding claim, wherein:
the edge area is divided into a plurality of areas (Area 1 - Area 4); and
edge second openings (OPBMb) located in a same area among the plurality of areas (Area 1 - Area 4) and corresponding to a same color pixel have a same size.

6. The light emitting display device (1000) of claim 5, wherein:
an edge second opening (OPBMb) of an area (Area 1) located closest to an outermost edge of the display area, among the plurality of areas (Area 1 - Area 5) of the edge area, is smallest of the edge second openings (OPBMb), and an edge second opening (OPBMb) of an area (Area 4) farthest from the outermost edge of the display area (DA) is largest of the edge second openings (OPBMb), and edge second openings in areas (Area 2 - Area 3) located sequentially inward from the outermost edge of the display area gradually increases.

7. The light emitting display device (1000) of claim 6, wherein an additional area located between two adjacent areas (Area 3, Area 4) among the plurality of areas of the edge area comprises edge second openings located in each of two areas located on either side of the additional area.
wherein, optionally, the additional area comprises the edge second openings (OPBMb) formed in each of two areas located on either side of the additional area in a 1:1 ratio.

8. The light emitting display device (1000) of any one of claims 5 - 7, wherein:
the first opening (OP) and the second opening (OPBM) of the display area (DA) each have a circular planar shape; and
the first opening (OP) and the second opening (OPBM) corresponding to each other have centers at the same position in a plan view.

9. The light emitting display device (1000) of any one of claims 5 - 8, wherein the first opening (OP) and/or the second opening (OPBM) located in the same area among the plurality of areas (Area 1 - Area 4) of the edge area and corresponding to different colors have different sizes.

10. The light emitting display device (1000) of any one of claims 5 - 9, wherein the edge second opening (OPBM) in the edge area has a planar shape extending toward an inner side of the display area (DA),
wherein, optionally:
the edge area is located along four sides of the display area (DA);
extending directions along which the edge second opening (OPBMb) is elongated from the edge area located on each side are the same; and
the extending directions along which the edge second opening (OPBMb) extends in the entire edge area are four in total.

11. The light emitting display device (1000) of any preceding claim, wherein the second opening (OPBM) is located in a light blocking layer (220) located in an upper portion of the pixel defining layer, or an overlapping light shielding area of a color filter.

12. A light emitting display device (1000), comprising:
a substrate (101) comprising a normal display area (DA) divided into an edge area and a central area;
an anode (Anode) located on the substrate (101);
a pixel defining layer (380) comprising a first opening (OP) configured to expose at least a portion of the anode (Anode);
an emission layer (EML) located within the first opening (OP) of the pixel defining layer (380);
a cathode (Cathode) configured to cover the pixel defining layer (380) and the emission layer (EML);
an encapsulation layer (400) configured to cover the cathode (Cathode) and comprising an organic encapsulation layer (402); and
a second opening (OPBM) located on the encapsulation layer (400), and corresponding to the first opening (OP) of the pixel defining layer (380),
wherein the second opening (OPBM) is divided into a central second opening (OPBMa) located in the central area and an edge second opening located in the edge area (OPBMb), and
wherein the edge second opening in the edge area (OPBMb) has a planar shape extending toward an inner side of the display area (DA).

13. The light emitting display device (1000) of claim 12, wherein:
the edge area is located along four sides of the display area (DA);
extending directions along which the edge second opening (OPBMb) is elongated from the edge area located on respective sides are the same; and
the extending directions along which the edge second opening (OPBMb) extends in the entire edge area are four in total.

14. The light emitting display device (1000) of claim 12 or claim 13, wherein the second opening (OPBM) is located in a light blocking layer (220) located in an upper portion of the pixel defining layer (380), or an overlapping light shielding area of a color filter.

15. An electronic device comprising a light emitting display device (1000) according to any preceding claim.
